# EUROPEAN PATENT SPECIFICATION

(11) **EP 1 139 357 B1**
(45) Date of publication and mention of the grant of the patent: **04.10.2006**
(21) Application number: 01106934.1
(22) Date of filing: 20.03.2001
(51) Int. Cl.: H01G 9/20

(54) **Photo-electrochemical cell**
Photoelektrochemische Zelle
Cellule photoélectrochimique

(30) Priority: 31.03.2000 JP 2000097563
(43) Date of publication of application: 04.10.2001
(73) Proprietor: FUJI PHOTO FILM CO., LTD., Minami-Ashigara-shi, Kanagawa-ken (JP)
(72) Inventor: Wariishi, Koji, Minami-Ashigara-shi, Kanagawa-ken (JP)
(74) Representative: Solf, Alexander

(56) References cited:
- WO-A-95/18456
- US-A- 5 622 791
- HAGFELDT A ET AL: "Photoelectrochemical studies of colloidal TiO/sub 2/-films: the charge separation process studied by means of action spectra in the UV region" SOLAR ENERGY MATERIALS AND SOLAR CELLS, SEPT. 1992, NETHERLANDS, vol. 27, no. 4, pages 293-304, XP000306632 ISSN: 0165-1633
- O'REGAN B ET AL: "LARGE ENHANCEMENT IN PHOTOCURRENT EFFICIENCY CAUSED BY UV ILLUMINATION OF THE DYE-SENSITIZED HETEROJUNCTION TIO2/RULL'NCS/CUSCN: INITIATION AND POTENTIAL MECHANISMS" CHEMISTRY OF MATERIALS, AMERICAN CHEMICAL SOCIETY, WASHINGTON, US, vol. 10, no. 6, 1998, pages 1501-1509, XP000907665 ISSN: 0897-4756
- BONHOTE P ET AL: "HUYDROPHOBIC, HIGHLY CONDUCTIVE AMBIENT-TEMPERATURE MOLTEN SALTS" INORGANIC CHEMISTRY, AMERICAN CHEMICAL SOCIETY, EASTON, US, vol. 35, no. 5, 1996, pages 1168-1178, XP000605807 ISSN: 0020-1669

## Description

### BACKGROUND OF THE INVENTION

The present invention relates to a photoelectric conversion device exhibiting high durability and excellent photoelectric conversion properties, and a photo-electrochemical cell composed of the photoelectric conversion device.

Solar cells for the solar power generation comprising monocrystalline silicon, polycrystalline silicon, amorphous silicon, cadmium telluride, indium copper selenide, etc. have been the subject of practical use and major object of research and development. However, for a widespread use of the solar cell as a home power source, etc., there are such problems as a high production cost, difficulty in security of raw materials, and a long energy payback time, therefore, these obstacles must be overcome.

Recently, a variety of solar cells using an organic material are proposed with the objects of increasing the surface area of the cell, lowering the price thereof, etc. For example, Nature, Vol. 353, Page 737 to 740 (1991), United States Patent No. 4,927,721, etc. disclosed a photoelectric conversion device and a solar cell comprising a semiconductor sensitized by a dye, and materials and a production method for making the same. This solar cell is such a wet-type cell that comprises a titanium dioxide porous thin film spectrally sensitized with a ruthenium complex dye as a working electrode, in which the titanium dioxide porous thin film is electrically connected to a counter electrode through a electrolyte solution. The primary advantage for this wet-type device is that a low-priced photoelectric conversion device can be provided because an inexpensive metal oxide semiconductor such as titanium dioxide can be used without purification to a high purity. However, the photoelectric conversion device and the solar cell generally have such disadvantages as a low conversion efficiency and a poor durability.

US 5,622,791 discloses a photoelectrochemical cell having increased conductivity. The cell employs an electrolyte formed from a polymeric matrix, an electrolytic solvent, an inorgranic ion salt and a redox couple.

Further, disclosed in WO 95/18456, Japanese Patent Laid-Open No. 8-259543, Denki Kagaku, 65, 11, 923 (1997), etc. are photoelectric conversion devices containing an electrolyte composition using a pyridinium salt, an imidazolium salt, a triazolium salt, etc. as electrolyte to prevent leakage and depletion of the electrolyte composition, thereby improving the durability of the device. The salts are liquid at room temperature, called as "room temperature molten salt". In such electrolyte composition, a solvent for dissolving the electrolyte such as water and organic solvents is not necessary or needed only a little amount, whereby the photoelectric conversion devices containing the composition exhibit improved durability. However, the devices using the room temperature molten salt generally poor in photoelectric conversion efficiency.

### OBJECT AND SUMMARY OF THE INVENTION

Accordingly, an object of the present invention is to provide a photoelectric conversion device exhibiting high durability and excellent photoelectric conversion properties, and a photo-electrochemical cell composed of the photoelectric conversion device.

As a result of intense research in view of the above object, the inventor has found that a photoelectric conversion device using an electrolyte composition that comprises a metal cation and a particular anion of a predetermined amount is excellent in durability and photoelectric conversion properties. The present invention has been accomplished by the finding.

Thus, a photoelectric conversion device of the present invention has a conductive support, a photosensitive layer containing a semiconductor, a charge transfer layer containing an electrolyte composition, and a counter electrode, wherein the electrolyte composition comprises 0.01 to 2.5 weight % of a metal cation, and 1 to 30 weight % of SCN- and an anion represented by the following general formula (1):

R_{f}-COO⁻ (1)

wherein R_{f} represents an alkyl group substituted by at least one fluorine atom, and wherein the metal cation is a lithium ion, a sodium ion or a magnesium ion and wherein said electrolyte composition comprises a molten salt.

A photo-electrochemical cell of the present invention is composed of the above photoelectric conversion device.

With respect to the photoelectric conversion device and the photo-electrochemical cell of the present invention, the durability and the photoelectric conversion properties are further improved by satisfying any of the following conditions (1) to (8).
(1) The metal cation is a lithium ion, a sodium ion or a magnesium ion.
(2) The electrolyte composition preferably comprises 0.02 to 2 weight % of the metal cation.
(3) R_{f} in the general formula (1) is particularly preferably a perfluoroalkyl group having I to 10 carbon atom.
(4) The electrolyte composition comprises a molten salt.
(5) The electrolyte composition preferably comprises 10 weight % or less of a solvent.
(6) The electrolyte composition preferably comprises an iodine salt and iodine.
(7) The photosensitive layer preferably contains semiconductor fine particles sensitized by a dye, and the dye is preferably a metal complex dye and/or a polymethine dye.
(8) The semiconductor is preferably composed of a metal chalcogenide, and the metal chalcogenide is preferably titanium oxide.

### BRIEF DESCRIPTION OF THE DRAWINGS

Fig. 1 is a partial cross sectional view showing a preferable structure of a photoelectric conversion device of the present invention,
Fig. 2 is a partial cross sectional view showing a preferable structure of a photoelectric conversion device of the present invention,
Fig. 3 is a partial cross sectional view showing a preferable structure of a photoelectric conversion device of the present invention,
Fig. 4 is a partial cross sectional view showing a preferable structure of a photoelectric conversion device of the present invention,
Fig. 5 is a partial cross sectional view showing a preferable structure of a photoelectric conversion device of the present invention,
Fig. 6 is a partial cross sectional view showing a preferable structure of a photoelectric conversion device of the present invention,
Fig. 7 is a partial cross sectional view showing a preferable structure of a photoelectric conversion device of the present invention,
Fig. 8 is a partial cross sectional view showing a preferable structure of a photoelectric conversion device of the present invention, and
Fig. 9 is a partial cross sectional view showing a preferable structure of a photoelectric conversion device of the present invention, and
Fig. 10 is a partial cross sectional view showing an example of a structure of a substrate-integrated type solar cell module comprising a photoelectric conversion device of the present invention.

### DETAILED DESCRIPTION OF THE PREFERRED EMBODIMENTS

### [1] Photoelectric Conversion Device

A photoelectric conversion device according to the present invention has a conductive support, a photosensitive layer containing a semiconductor, a charge transfer layer containing an electrolyte composition, and a counter electrode.

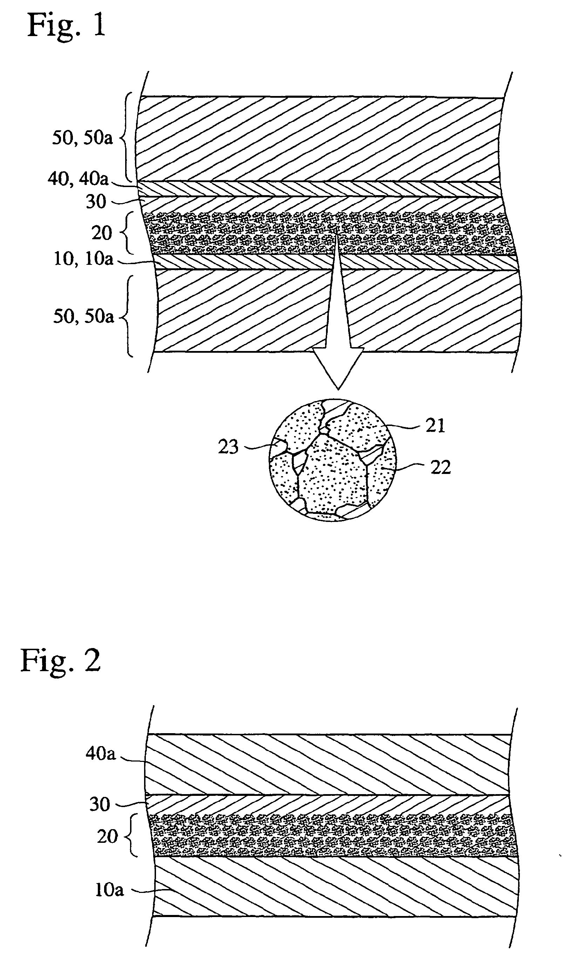

As shown in Fig. 1, the photoelectric conversion device preferably comprises an electrically conductive layer 10, a photosensitive layer 20 composed of semiconductor fine particles 21 sensitized by a dye 22 and an charge-transporting material 23 penetrated into voids among the particles, a charge transfer layer 30, and a counter electrically conductive layer 40 laminated in this order. The charge-transporting material 23 is preferably the same as the electrolyte composition used in the charge transfer layer 30. On the electrically conductive layer 10 and/or the counter electrically conductive layer 40 may be disposed a substrate 50 to improve the strength of the photoelectric conversion device. Hereinafter in the present invention, a layer composed of the electrically conductive layer 10 and the substrate 50 disposed thereon if necessary is referred to as "conductive support", and a layer composed of the counter electrically conductive layer 40 and the substrate 50 disposed thereon if necessary is referred to as "counter electrode". A photo-electrochemical cell of the present invention is constituted by connecting the device to an outer circuit. Incidentally, the electrically conductive layer 10, the counter electrically conductive layer 40 and the substrate 50 shown in Fig. 1 may be a transparent electrically conductive layer 10a, a transparent counter electrically conductive layer 40a and a transparent substrate 50a, respectively.

In the photoelectric conversion device shown in Fig. 1, a light injected to the photosensitive layer 20 excites the dye 22, etc., excited high energy electrons therein are transported to a conduction band of the semiconductor fine particles 21, and they are diffused to reach to the electrically conductive layer 10. At this time, the dye 22 is in oxidized form. In the photo-electrochemical cell, electrons in the electrically conductive layer 10 are returned to the oxidized dye through the counter electrically conductive layer 40 and the charge transfer layer 30 while working in the outer circuit, so that the dye 22 is regenerated. The photosensitive layer 20 also acts as a negative electrode. In a boundary of each layer such as a boundary between the electrically conductive layer 10 and the photosensitive layer 20, a boundary between the photosensitive layer 20 and the charge transfer layer 30, a boundary between the charge transfer layer 30 and the counter electrically conductive layer 40, etc., components of each layer may be diffused and mixed. Each of the layers will be explained in detail below.

### (A) Charge Transfer Layer

The charge transfer layer replenishes electrons to the oxidized dye. The charge transfer layer contains an electrolyte composition comprising a metal cation and a particular anion of a predetermined amount.

The electrolyte composition comprises a metal cation, and SCN- and an anion represented by the following general formula (1):

R_{f}-COO⁻ (1)

wherein R_{f} represents an alkyl group substituted by at least one fluorine atom, and wherein the metal cation is a lithium ion a sodium ion or a magnesium ion and wherein said electrolyte composition comprises a molten salt. The metal cation and SCN⁻ and the anion represented by the general formula (1) act to improve both of an open circuit voltage and a short-circuit current density of the photoelectric conversion device.

Weight ratio of the metal cation to the entire electrolyte composition is 0.01 to 2.5 weight %, preferably 0.02 to 2 weight %. When the weight ratio is less than 0.01 weight %, the short-circuit current density of the photoelectric conversion device is not improved. On the other hand, when the weight ratio is more than 2.5 weight %, the charge-transporting capability of the electrolyte composition is insufficient to lower the photoelectric conversion efficiency of the photoelectric conversion device.

Weight ratio of SCN⁻ and the anion represented by the general formula (1) to the entire electrolyte composition is 1 to 30 weight %, preferably 2 to 25 weight %. When the weight ratio is less than 1 weight %, the open circuit voltage of the photoelectric conversion device is not improved. On the other hand, when the weight ratio is more than 30 weight %, the charge-transporting capability of the electrolyte composition is insufficient to lower the photoelectric conversion efficiency of the photoelectric conversion device.
The metal cation is a lithium ion, a sodium ion or a magnesium ion. The metal cation is preferably added to the electrolyte composition as a salt composed of the metal cation, SCN⁻ and the anion represented by the general formula (1), or as a metal iodide.

In the general formula (1), R_{f}⁻ represents an alkyl group substituted by at least one fluorine atom. The alkyl group preferably has 1 to 20 carbon atom, more preferably has 1 to 10 carbon atom. R_{f} is particularly preferably a perfluoroalkyl group having 1 to 10 carbon atom.

The anion represented by the general formula (1) may be such as derived from carboxylic acids (R_{f}COOH) shown in "Fluoro Organic Compounds & Fluorinating Agents" published by Daikin Chemical Sales, K. K., and "Fluorine Compounds" published by Wako Pure Chemical Industries, Ltd. Specific examples of the anion represented by the general formula (1) include CHF₂COO⁻, CF₃COO⁻, CF₃CF₂COO⁻, etc. This anion may form an oligomer (or polymer) through R_{f}, and the oligomer is preferably a dimer.

SCN⁻ and the anion represented by the general formula (1) may form a salt with the metal cation mentioned above to be added to the electrolyte composition. Also, they may form a molten salt (a pyridinium salt, an imidazolium salt, a triazolium salt, etc.) with an organic cation described below.

Specific examples of the salt composed of the metal cation, SCN⁻ and the anion represented by the general formula (1), and the metal iodide preferably used in the present invention will be illustrated below without intention of restricting the scope of the present invention defined by the claims attached hereto.

| | | | |
|---|---|---|---|
| 1-1 | CF₃COO⁻M⁺ | 1-2 | CF₃(CF₂)₂COO⁻M⁺ |
| | 1-1a: M=Li | | 1-2a: M=Li |
| | 1-1b: M=Na | | 1-2b: M=Na |
| | | | |
| 1-3 | CF₃(CF₂)₉COO⁻M⁺ | 1-4 | (CF₃COO⁻)₂M²⁺; |
| | 1-3a: M=Li | | 1-4a: M=Mg |
| | 1-3b: M=Na | | |
| | | | |
| 1-5 | ⁺M⁻OOC⁻(CF₂)₃-COO⁻M⁺ | | |
| | 1-5a: M=Li | | |
| | 1-5b: M=Na | | |
| | | | |
| 2-1 : | LiSCN | | |
| 2-2 : | NaSCN | | |
| 2-3 : | KSCN | | |
| 2-4: | Nal | | |
| 2-5: | Mgl₂ | | |

Components of the electrolyte composition other than the ions mentioned above, and a method for forming the charge transfer layer will be described in detail below.

### (1) Electrolyte

The electrolyte composition comprises a molten salt as an electrolyte for transporting charge. Examples of the electrolyte include: molten salt electrolytes containing redox couple; so-called gel electrolytes where a redox couple solution is penetrated into a polymer matrix; solid electrolytes; electrolysis solutions where a redox couple is dissolved in a solvent; etc. Among them, the molten salt electrolytes are preferable from the viewpoint of improving both of the durability and the photoelectric conversion efficiency of the photoelectric conversion device. Further, electron-transporting materials and hole-transporting materials, which transport charge by carrier transfer in the solid, may be used for the charge transfer layer.

The molten salts usable in the present invention are, for example, the known iodine salts such as pyridinium iodides, imidazolium iodides and triazolium iodides disclosed in WO 95/18456, Japanese Patent Laid-Open No. 8-259543, Denki Kagaku, 65, 11, 923 (1997), etc.

The molten salts used in the present invention are preferably represented by any of the following general formulae (Y-a), (Y-b) and (Y-c).

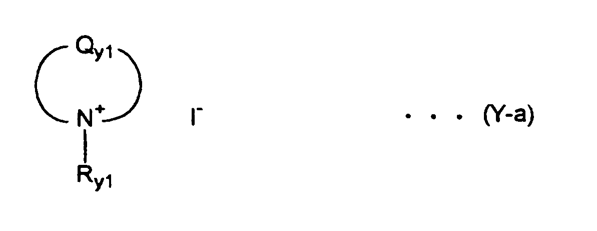

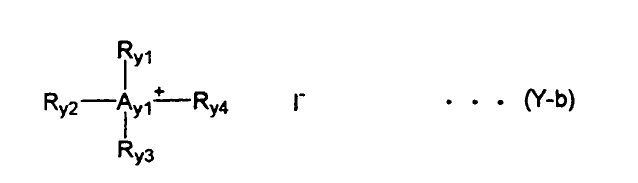

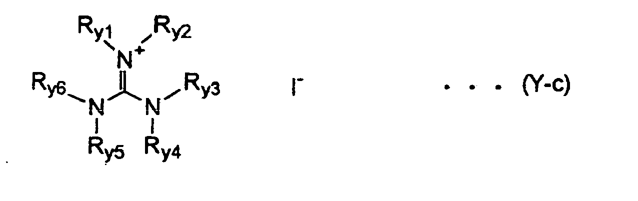

In the general formula (Y-a), Q_{y1} represents an atomic group forming an aromatic cation having a 5- or 6-membered ring structure with a nitrogen atom. Q_{y1} is preferably composed of atoms selected from the group consisting of carbon, hydrogen, nitrogen, oxygen and sulfur atoms.

As for the 5-membered ring formed by Q_{y1}, preferred are such rings as an oxazole ring, a thiazole ring, an imidazole ring, a pyrazole ring, an iso-oxazole ring, a thiadiazole ring, an oxadiazole ring and a triazole ring. The 5-membered ring is more preferably an oxazole ring, a thiazole ring or an imidazole ring, particularly preferably an oxazole ring or an imidazole ring. As for the 6-membered ring formed by Q_{y1}, preferred are such rings as a pyridine ring, a pyrimidine ring, a pyridazine ring, a pyrazine ring and a triazine ring. The 6-membered ring is more preferably a pyridine ring.

In the general formula (Y-b), A_{y1} represents a nitrogen atom or a phosphorus atom.

R_{y1} to R_{y6} in the general formulae (Y-a), (Y-b) and (Y-c) independently represent: a substituted or unsubstituted alkyl group preferably having 1 to 24 carbon atom, which may be straight or branched, or cyclic, such as a methyl group, an ethyl group, a propyl group, an isopropyl group, a pentyl group, a hexyl group, an octyl group, a 2-ethylhexyl group, a *t*-octyl group, a decyl group, a dodecyl group, a tetradecyl group, a 2-hexyldecyl group, an octadecyl group, a cyclohexyl group, a cyclopentyl group, etc.; or a substituted or unsubstituted alkenyl group preferably having 2 to 24 carbon atoms, which may be straight or branched, such as a vinyl group, an allyl group, etc. R_{y1} to R_{y6} is more preferably an alkyl group having 2 to 18 carbon atoms or an alkenyl group having 2 to 18 carbon atoms, particularly preferably an alkyl group having 2 to 6 carbon atoms.

Two or more of R_{y1} to R_{y4} in the general formula (Y-b) may be bonded together to form a non-aromatic ring containing A_{y1}. Two or more of R_{y1} to R_{y6} in the general formula (Y-c) may be bonded together to form a ring.

Q_{y1} and R_{y1} to R_{y6} in the general formulae (Y-a), (Y-b) and (Y-c) may have a substituent. Preferable examples of the substituent include: a halogen atom such as F, Cl, Br and I; a cyano group; an alkoxy group such as a methoxy group and an ethoxy group; an aryloxy group such as a phenoxy group; an alkylthio group such as a methylthio group and an ethylthio group; an alkoxycarbonyl group such as an ethoxycarbonyl group; a carbonate group such as an ethoxycarbonyloxy group; an acyl group such as an acetyl group, a propionyl group and a benzoyl group; a sulfonyl group such as a methane sulfonyl group and a benzene sulfonyl group; an acyloxy group such as an acetoxy group and a benzoyloxy group; a sulfonyloxy group such as a methane sulfonyloxy group and a toluene sulfonyloxy group; a phosphonyl group such as a diethylphosphonyl group; an amido group such as an acetylamino group and a benzoylamino group; a carbamoyl group such as an *N*,*N*-dimethylcarbamoyl group; an alkyl group such as a methyl group, an ethyl group, a propyl group, an isopropyl group, a cyclopropyl group, a butyl group, a 2-carboxyethyl group and a benzyl group; an aryl group such as a phenyl group and a toluyl group; a heterocyclic group such as a pyridyl group, an imidazolyl group and a furanyl group; an alkenyl group such as a vinyl group and a 1-propenyl group; a silyl group such as a trimethylsilyl group, a *t*-butyldimethylsilyl group and a phenyldimethylsilyl group; a silyloxy group such as a trimethylsilyloxy group and a t-butyldimethylsilyloxy group; etc. Among them, preferred are an alkoxy group, an alkyl group, a silyl group and silyloxy group.

The molten salt represented by the general formula (Y-a), (Y-b) or (Y-c) may form an oligomer (polymer) through Q_{y1} or R_{y1} to R_{y6}. The molten salt represented by the general formula (Y-a), (Y-b) or (Y-c) may be used singly or as a mixture containing a plurality thereof.

The molten salt represented by the general formula (Y-a), (Y-b) or (Y-c) may be used with such a salt that I⁻ thereof is replaced into the other anion. The other anion is preferably halide ions such as Cl⁻ and Br⁻, NCS⁻, BF₄⁻, PF₆⁻, ClO₄⁻ , N⁻(SO₂CF₃)₂, N⁻(SO₂CF₂CF₃)₂, CF₃SO₃⁻, CF₃COO⁻, BPh₄⁻, C⁻(SO₂CF₃)₃, etc., more preferably NCS⁻, BF₄⁻, N⁻(SO₂CF₃)₂ or CF₃COO⁻. Also, the iodine salt represented by the general formula (Y-a), (Y-b) or (Y-c) may be used with another iodine salt such as LiI, etc.

The molten salts preferably used in the present invention will be illustrated below without intention of restricting the scope of the present invention defined by the claims attached hereto.

| | | | |
|---|---|---|---|
| (Y1) | 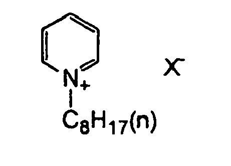 | Y1-1 X=I | Y1-4 X=PF₆ |
| | | Y1-2 X=BF₄ | Y1-5 X=CF₃COO |
| | | Y1-3 X=N(SO₂CF₃)₂ | Y1-6 X=SCN |
| (Y2) | 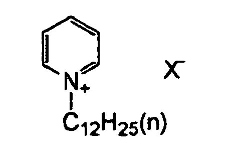 | Y2-1 X=I | Y2-4 X=PF₆ |
| | | Y2-2 X=BF₄ | Y2-5 X=CF₃COO |
| | | Y2-3 X=N(SO₂CF₃)₂ | Y2-6 X=SCN |
| (Y3) | 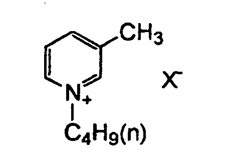 | Y3-1 X=I | Y3-4 X=CF₃COO |
| | | Y3-2 X=BF₄ | Y3-5 X=SCN |
| | | Y3-3 X=N(SO₂CF₃)₂ | |
| (Y4) | 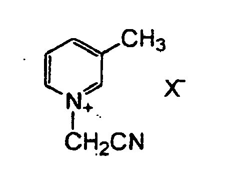 | Y4-1 X=I | Y4-4 X=CF₃COO |
| | | Y4-2 X=BF₄ | Y4-5 X=SCN |
| | | Y4-3 X=N(SO₂CF₃)₂ | |
| (Y5) | 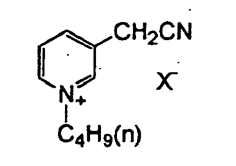 | Y5-1 X=I | Y5-4 X=CF₃COO |
| | | Y5-2 X=BF₄ | Y5-5 X=SCN |
| | | Y5-3 X=N(SO₂CF₃)₂ | |
| (Y6) | 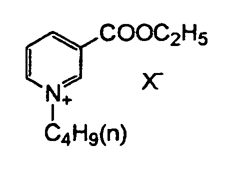 | Y6-1 X=I | Y6-4 X=CF₃COO |
| | | Y6-2 X=BF₄ | Y6-5 X=SCN |
| | | Y6-3 X=N(SO₂CF₃)₂ | |
| (Y7) | 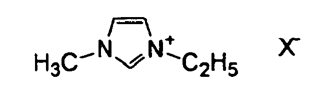 | Y7-1 X=I | Y7-4 X=Br |
| | | Y7-2 X=BF₄ | Y7-5 X=CF₃COO |
| | | Y7-3 X=N(SO₂CF₃)₂ | Y7-6 X=SCN |
| | | Y7-7 X=CF₃CF₂CF₂COO | |
| (Y8) | 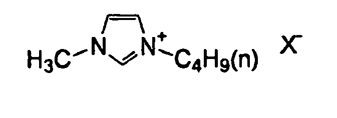 | Y8-1 X=I | Y8-4 X=CF₃COO |
| | | Y8-2 X=BF₄ | Y8-5 X=SCN |
| | | Y8-3 X=N(SO₂CF₃)₂ | |
| (Y9) | 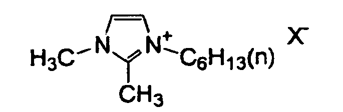 | Y9-1 X=I | Y9-4 X=CF₃COO |
| | | Y9-2 X=BF₄ | Y9-5 X=SCN |
| | | Y9-3 X=N(SO₂CF₃)₂ | |
| (Y10) | 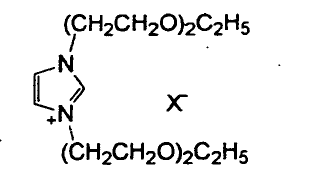 | Y10-1 X=I | Y10-4 X=CF₃COO |
| | | Y10-2 X=BF₄ | Y10-5 X=SCN |
| | | Y10-3 X=N(SO₂CF₃)₂ | |
| (Y11) | 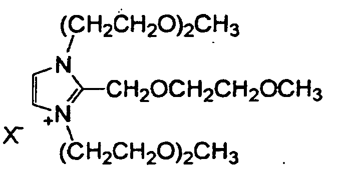 | Y11-1 X=I | Y11-4 X=CF₃COO |
| | | Y11-2 X=BF₄ | Y11-5 X=SCN |
| | | Y11-3 X=N(SO₂CF₃)₂ | |
| (Y12) | 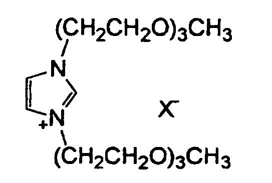 | Y12-1 X=I | Y12-4 X=CF₃COO |
| | | Y12-2 X=BF₄ | Y12-5 X=SCN |
| | | Y12-3 X=N(SO₂CF₃)₂ | |
| (Y13) | 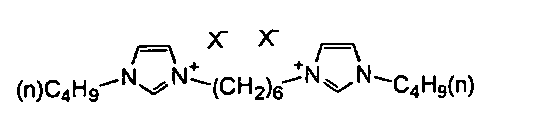 | | |
| | Y13-1 X=I | Y13-4 X=CF₃COO | |
| | Y13-2 X=BF₄ | Y13-5 X=SCN | |
| | Y13-3 X=N(SO₂CF₃)₂ | | |
| (Y14) | 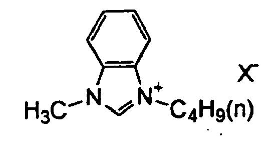 | Y14-1 X=I | Y14-4 X=CF₃COO |
| | | Y14-2 X=BF₄ | Y14-5 X=SCN |
| | | Y14-3 X=N(SO₂CF₃)₂ | |
| (Y15) | 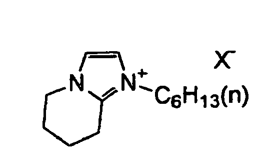 | Y15-1 X=I | Y15-4 X=CF₃COO |
| | | Y15-2 X=BF₄ | Y15-5 X=SCN |
| | | Y15-3 X=N(SO₂CF₃)₂ | |
| (Y16) | 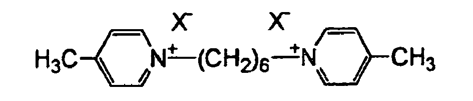 | | |
| | Y16-1 X=I | Y16-4 X=CF₃COO | |
| | Y16-2 X=BF₄ | Y16-5 X=SCN | |
| | Y16-3 X=N(SO₂CF₃)₂ | | |
| (Y17) | 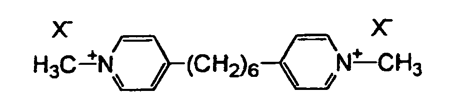 | | |
| | Y17-1 X=I | Y17-4 X=CF₃COO | |
| | Y17-2 X=BF₄ | Y17-5 X=SCN | |
| | Y17-3 X=N(SO₂CF₃)₂ | | |
| (Y18) | 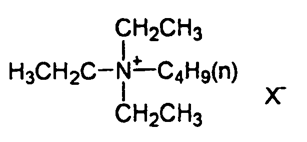 | Y18-1 X=I | Y18-4 X=PF₆ |
| | | Y18-2 X=BF₄ | Y18-5 X=CF₃COO |
| | | Y18-3 X=N(SO₂CF₃)₂ | Y18-6 X=SCN |
| (Y19) | 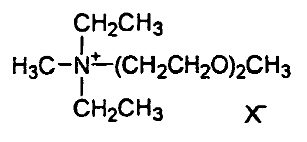 | Y19-1 X=I | Y19-4 X=CF₃COO |
| | | Y19-2 X=BF₄ | Y19-5 X=SCN |
| | | Y19-3 X=N(SO₂CF₃)₂ | |
| (Y20) | 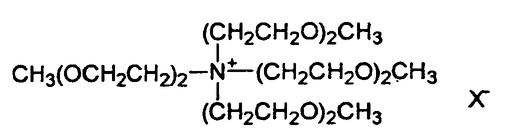 | | |
| | Y20-1 X=I | Y20-4 X=CF₃COO | |
| | Y20-2 X=BF₄ | Y20-5 X=SCN | |
| | Y20-3 X=N(SO₂CF₃)₂ | | |
| (Y21) | 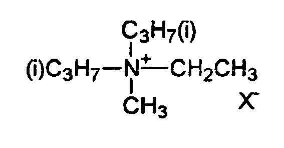 | Y21-1 X=I | Y21-4 X=CF₃COO |
| | | Y21-2 X=BF₄ | Y21-5 X=SCN |
| | | Y21-3 X=N(SO₂CF₃)₂ | |
| (Y22) | 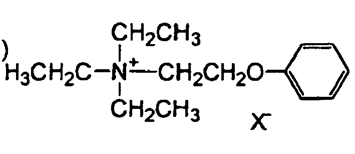 | Y22-1 X=I | Y22-4 X=CF₃COO |
| | | Y22-2 X=BF₄ | Y22-5 X=SCN |
| | | Y22-3 X=N(SO₂CF₃)₂ | |
| (Y23) | 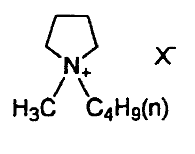 | Y23-1 X=I | Y23-4 X=CF₃COO |
| | | Y23-2 X=BF₄ | Y23-5 X=SCN |
| | | Y23-3 X=N(SO₂CF₃)₂ | |
| (Y24) | 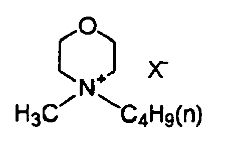 | Y24-1 X=I | Y24-4 X=CF₃COO |
| | | Y24-2 X=BF₄ | Y24-5 X=SCN |
| | | Y24-3 X=N(SO₂CF₃)₂ | |
| (Y25) | 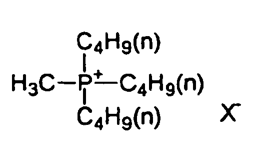 | Y25-1 X=I | Y25-4 X=CF₃COO |
| | | Y25-2 X=BF₄ | Y25-5 X=SCN |
| | | Y25-3 X=N(SO₂CF₃)₂ | |
| (Y26) | 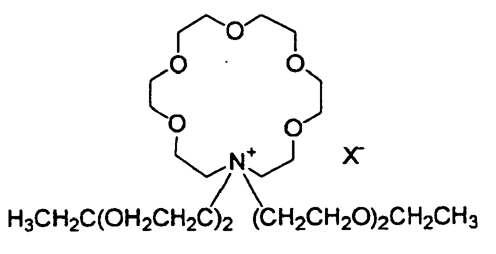 | Y26-1 X=l | Y26-4 X=CF₃COO |
| | | Y26-2 X=BF₄ | Y26-5 X=SCN |
| | | Y26-3 X=N(SO₂CF₃)₂ | |
| (Y27) | 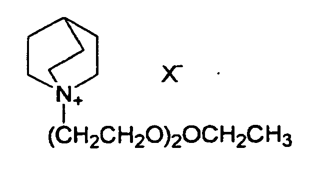 | Y27-1 X=I | Y27-4 X=CF₃COO |
| | | Y27-2 X=BF₄ | Y27-5 X=SCN |
| | | Y27-3 X=N(SO₂CF₃)₂ | |
| (Y28) | 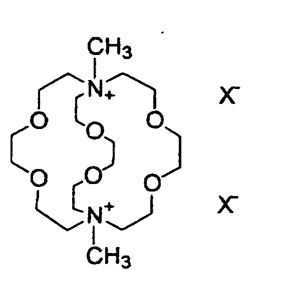 | Y28-1 X=I | Y28-4 X=CF₃COO |
| | | Y28-2 X=BF₄ | Y28-5 X=SCN |
| | | Y28-3 X=N(SO₂CF₃)₂ | |
| (Y29) | 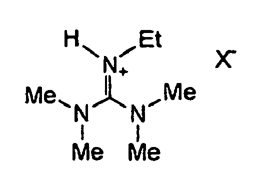 | Y29-1 X=I | Y29-4 X=PF₆ |
| | | Y29-2 X=N(SO₂CF₃)₂ | Y29-5 X=CF₃COO |
| | | Y29-3 X=BF₄ | Y29-6 X=SCN |
| (Y30) | 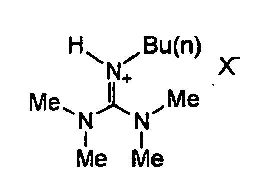 | Y30-1 X=I | Y30-4 X=CF₃SO₃ |
| | | Y30-2 X=N(SO₂CF₃)₂ | Y30-5 X=CF₃COO |
| | | Y30-3 X=BF₄ | Y30-6 X=SCN |
| (Y31) | 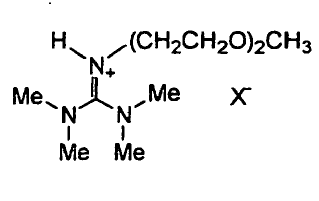 | Y31-1 X=I | Y31-4 X=CF₃COO |
| | | Y31-2 X=N(SO₂CF₃)₂ | Y31-5 X=SCN |
| | | Y31-3 X=BF₄ | |
| (Y32) | 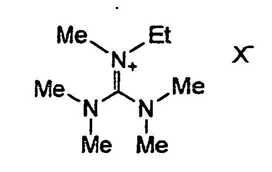 | Y32-1 X=I | Y32-4 X=CF₃COO |
| | | Y32-2 X=N(SO₂CF₃)₂ | Y32-5 X=SCN |
| | | Y32-3 X=BF₄ | |
| (Y33) | 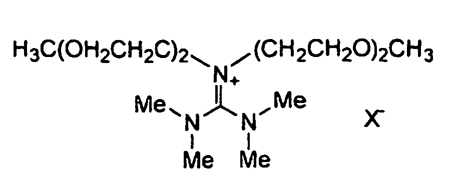 | | |
| | Y33-1 X=I | Y33-4 X=CF₃COO | |
| | Y33-2 X=N(SO₂CF₃)₂ | Y33-5 X=SCN | |
| | Y33-3 X=BF₄ | | |
| (Y34) | 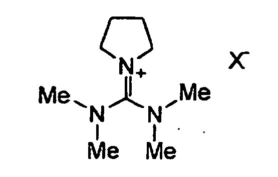 | Y34-1 X=I | Y34-4 X=CF₃COO. |
| | | Y34-2 X=N(SO₂CF₃)₂ | Y34-5 X=SCN |
| | | Y34-3 X=BF₄ | |
| (Y35) | 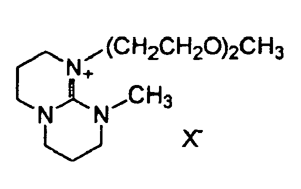 | Y35-1 X=I | Y35-4 X=CF₃COO |
| | | Y35-2 X=N(SO₂CF₃)₂ | Y35-5 X=SCN |
| | | Y35-3 X=BF₄ | |
| (Y36) | 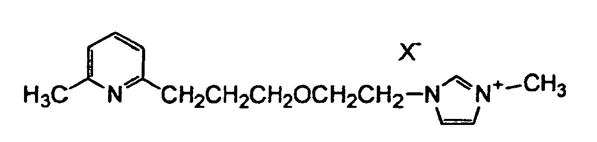 | | |
| | Y36-1 X=I | Y36-4 X=CF₃COO | |
| | Y36-2 X=N(SO₂CF₃)₂ | Y36-5 X=SCN | |
| | Y36-3 X=BF₄ | | |
| (Y37) | 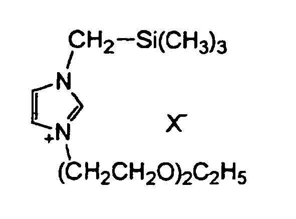 | Y37-1 X=I | Y37-4 X=CF₃COO |
| | | Y37-2 X=N(SO)₂CF₃)₂ | Y37-5 X=SCN |
| | | Y37-3 X=BF₄ | |

The electrolyte composition may comprise a solvent. In the case of the electrolyte composition comprising the molten salt, the solvent-content of the electrolyte composition is preferably 20 weight % or less, more preferably 10 weight % or less based on the entire composition, and it is the most preferable that the electrolyte composition comprises no solvent.

The electrolyte composition may be gelled (solidified) at practical use. The gelation may be achieved by: adding a polymer; adding an oil-gelling agent; polymerization of monomers comprising multifunctional monomers; a cross-linking reaction of a polymer; etc.

In the case where the electrolyte composition is gelled by adding a polymer, compounds described in "Polymer Electrolyte Reviews-1 and 2", edited by J. R. MacCallum and C. A. Vincent, ELSEIVER APPLIED SCIENCE may be used as the polymer. Polyacrylonitrile or poly(vinylidene fluoride) is preferably used.

In the case where the electrolyte composition is gelled by adding an oil-gelling agent, compounds described in J. Chem. Soc. Japan, Ind. Chem. Soc., 46, 779 (1943), J. Am. Chem. Soc., 111, 5542 (1989), J. Chem. Soc., Chem. Commun., 390 (1993), Angew. Chem. Int. Ed. Engl., 35, 1949 (1996), Chem. Lett., 885 (1996), J. Chem. Soc., Chem. Commun., 545 (1997), etc. may be used as the oil-gelling agent. Of the compounds, preferred are those having an amide structure.

In the case where a gel electrolyte composition is formed by polymerization of multifunctional monomers, the gelation is preferably achieved by the method comprising the steps of: preparing a solution composed of the multifunctional monomers, a polymerization initiator, the electrolyte and a solvent; forming a sol electrolyte layer on an electrode having a dye by a casting method, a coating method, a soaking method, an impregnation method, etc.; and radical-polymerizing the multifunctional monomers. It is preferable that the multifunctional monomer has two or more ethylenycally unsaturated groups. Preferable examples thereof include divinyl benzene, ethyleneglycol diacrylate, ethyleneglycol dimethacrylate, diethyleneglycol diacrylate, diethyleneglycol dimethacrylate, triethyleneglycol diacrylate, triethyleneglycol dimethacrylate, pentaerythritol triacrylate and trimethylolpropane triacrylate.

The gel electrolyte composition may be formed by polymerizing a mixture containing the multifunctional monomers and unifunctional monomers. Preferable examples of the unifunctional monomers include: acrylic acid and α-alkylacrylic acids (e.g. acrylic acid, methacrylic acid, itaconic acid, etc.), and esters or amides derived therefrom (e.g. methyl acrylate, ethyl acrylate, *n*-propyl acrylate, *i*-propyl acrylate, *n*-butyl acrylate, *i*-butyl acrylate, *t*-butyl acrylate, *n-*pentyl acrylate, 3-pentyl acrylate, *t*-pentyl acrylate, *n*-hexyl acrylate, 2,2-dimethylbutyl acrylate, *n*-octyl acrylate, 2-ethylhexyl acrylate, 4-methyl-2-propylpentyl acrylate, cetyl acrylate, *n*-octadecyl acrylate, cyclohexyl acrylate, cyclopentyl acrylate, benzyl acrylate, hydroxyethyl acrylate, 2-hydroxypropyl acrylate, 2-methoxyethyl acrylate, 2-ethoxyethyl acrylate, 2-methoxyethoxyethyl acrylate, phenoxyethyl acrylate, 3-methoxybutyl acrylate, ethylcarbitol acrylate, 2-methyl-2-nitropropyl acrylate, 2,2,2-trifluoroethyl acrylate, octafluoropentyl acrylate, heptadecafluorodecyl acrylate, methyl methacrylate, *n*-butyl methacrylate, *i*-butyl methacrylate, *t*-butyl methacrylate, *t-*pentyl methacrylate, *n*-octadecyl methacrylate, benzyl methacrylate, hydroxyethyl methacrylate, 2-hydroxypropyl methacrylate, 2-methoxyethyl methacrylate, 2-ethoxyethyl methacrylate, 2-methoxyethoxyethyl methacrylate, dimethylaminoethyl methacrylate, 2,2,2-trifluoroethyl methacrylate, tetrafluoropropyl methacrylate, hexafluoropropyl methacrylate, heptadecafluorodecyl methacrylate, ethyleneglycol ethyl carbonate methacrylate, 2-isobornyl methacrylate, 2-norbornylmethyl methacrylate, 5-norbornen-2-ylmethyl methacrylate, 3-methyl-2-norbornylmethyl methacrylate, acrylamide, *N*-*i*-propyl acrylamide, *N*-*n*-butyl acrylamide, *N-t*-butyl acrylamide, *N,N*-dimethyl acrylamide, *N*-methylol acrylamide, diacetone acrylamide, 2-acrylamido-2-methylpropane sulfonic acid, acrylamidopropyltrimethyl ammonium chloride, methacrylamide, *N*-methylmethacrylamide, *N-*methylolmethacrylamide, etc.); vinyl esters (e.g. vinyl acetate, etc.); maleic acid and fumaric acid, and esters derived therefrom (e.g. dimethyl maleate, dibutyl maleate, diethyl fumarate, etc.); acrylonitrile and methacrylonitrile; dienes (e.g. butadiene, cyclopentadiene, isoprene, etc.); aromatic vinyl compounds (e.g. styrene, *p*-chlorostyrene, *t*-butylstyrene, α-methylstyrene, sodium *p-*styrenesulfonate, etc.); *N*-vinylformamide, *N*-vinyl-*N*-methylformamide, *N-*vinylacetamide, and *N*-vinyl-*N*-methylacetamide; vinyl sulfonic acid; sodium vinylsulfonate, sodium allylsulfonate and sodium methacrylsulfonate; vinylidene fluoride and vinylidene chloride; vinyl alkyl ethers (e.g. methyl vinyl ether, etc.); ethylene, propylene, 1-butene and isobutene; and N-phenyl maleimide.

The weight ratio of the multifunctional monomers to all the monomers is preferably 0.5 to 70 weight %, more preferably 1.0 to 50 weight %.

The above-described monomers can be polymerized by general radical polymerization method described in Takayuki Otsu and Masaetsu Kinoshita, "Kobunshi Gosei no Jikkenho" (Kagaku Dojin), Takayuki Otsu, "Koza Jugo Hannoron 1 Rajikaru Jugo (I)" (Kagaku Dojin), etc. The radical polymerization may be achieved by heating, light or electron ray, or electrochemical method. Among them, heat-polymerization is particularly preferable.

Preferable examples of the polymerization initiator used in the present invention include: azo initiators such as 2,2'-azobis(isobutyronitrile), 2,2'-azobis(2,4-dimethylvaleronitrile), dimethyl 2,2'-azobis(2-methylpropionate) and dimethyl 2,2'-azobis(isobutyate); peroxide initiators such as lauryl peroxide, benzoyl peroxide and t-butyl peroctoate; etc. The weight ratio of the initiator to all the monomers is preferably 0.01 to 20 weight %, more preferably 0.1 to 10 weight %.

In the case where the gelation of the electrolyte composition is accomplished by the cross-linking reaction of polymer, a polymer containing a group having cross-linking reactivity is preferably added to the composition in combination with a cross-linking agent. The group having cross-linking reactivity is preferably a nitrogen-containing heterocyclic group such as a pyridyl group, an imidazolyl group, a thiazolyl group, an oxazolyl group, a triazolyl group, a morpholyl group, a piperidyl group, a piperazyl group, etc. Preferable cross-linking agent is an electrophilic agent having a plurality of functional group that can be attacked by the nitrogen atom, for example, multifunctional alkyl halides, aralkyl halides, sulfonates, acid anhydrides, acyl chlorides and isocyanates.

To the electrolyte composition may be also added such an electrolyte as: a combination of I₂ and iodide (a metal iodide such as LiI, NaI, KI, CsI and CaI₂, a quaternary ammonium iodide such as a tetralkylammonium iodide, pyridinium iodide and imidazolium iodide, etc.); a combination of Br₂ and bromide (a metal bromide such as LiBr, NaBr, KBr, CsBr and CaBr₂, a quaternary ammonium bromide such as a tetralkylammonium bromide and pyridinium bromide, etc.); a metal complex such as a ferrocyanide-ferricyanide and a ferrocene-ferricinium ion; a sulfur compound such as sodium polysulfide and alkylthiol-alkyldisulfide; a viologen dye; hydroquinone-quinone; etc. A plurality of the electrolytes may be mixed to be in use.

In the present invention, an organic hole-transporting material, an inorganic hole-transporting material, or a combination thereof may be used for the charge transfer layer together with the electrolyte. Prefferred examples of the organic hole-transporting material include aromatic tertiary amines, oligothiophene compounds, polythiophene compounds, polypyrrole compounds, polyacetylene derivatives, poly-*p*-phenylene derivatives, 2,2',7,7'-tetrakis(*N,N-*di-*p*-methoxyphenylamine)-9,9'-spirobifluorene and analogues thereof, etc. Examples of the inorganic hole-transporting material include p-type inorganic semiconductors such as CuI, CuSCN, CuInSe₂, Cu(In,Ga)Se_{2,} CuGaSe₂, Cu₂O, CuS, CuGaS₂, CuInS₂, CuAlSe₂, GaP, NiO, CoO, FeO, Bi₂O₃, MoO₂ and Cr₂O₃, etc.

### (2) Solvent and Additive

The electrolyte composition used in the present invention may comprise a solvent. The solvent-content of the electrolyte composition is preferably 10 weight % or less based on the entire electrolyte composition. The solvent used in the present invention is preferably such that has a low viscosity and a high ionic mobility, and/or that has a high permittivity and can increase the actual carrier concentration of the electrolyte composition, to exhibit an excellent ionic conductibility.

Examples of the solvent include: carbonates such as ethylene carbonate and propylene carbonate; heterocyclic compounds such as 3-methyl-2-oxazolidinone; ethers such as dioxan and diethyl ether; chain ethers such as ethyleneglycol dialkylethers, propyleneglycol dialkylethers, polyethyleneglycol dialkylethers and polypropyleneglycol dialkylethers; alcohols such as methanol, ethanol, ethyleneglycol monoalkylethers, propyleneglycol monoalkylethers, polyethyleneglycol monoalkylethers and polypropyleneglycol monoalkylethers; glycols such as ethylene glycol, propylene glycol, polyethylene glycol, polypropylene glycol and glycerin; nitriles such as acetonitrile, glutarodinitrile, methoxyacetonitrile, propionitrile, benzonitrile and biscyanoethyl ether; esters such as carboxylates, phosphates and phosphonates; aprotic polar solvents such as dimethylsulfoxide (DMSO) and sulfolane; water; etc. These solvents may be mixed to use.

Further, to the electrolyte composition may be added a basic compound such as *t*-butylpyridine, 2-picoline, 2,6-lutidine, etc. described in J. Am. Ceram. Soc., 80 (12), 3157 to 3171 (1997). The concentration of the basic compound is preferably 0.05 to 2 M based on the electrolyte composition.

### (3) Iodine Salt and Iodine

The electrolyte composition preferably comprises an iodine salt and iodine as a redox couple. The iodine salt may be the above-mentioned molten salt or a known iodine salt. The content of the iodine salt is preferably 10 to 99 weight %, more preferably 50 to 95 weight % based on the entire electrolyte composition. The iodine-content is preferably 0.1 to 20 weight %, more preferably 0.5 to 5 weight % based on the entire electrolyte composition.

Iodine may be added to the electrolyte composition by: adding iodine to the electrolyte solution; placing the conductive support disposed the charge transfer layer thereon in a sealed vessel with iodine to diffuse iodine into the electrolyte composition; etc. Further, iodine may be coated or vapor-deposited on the counter electrode before constituting the photoelectric conversion device, whereby iodine is introduced to the charge transfer layer when the photoelectric conversion device is constituted.

### (4) Method for Forming Charge Transfer Layer

The charge transfer layer comprising the electrolyte composition may be provided by applying the electrolyte composition to the photosensitive layer, and, if necessary, by heating the applied composition to cross-linking it. Application of the electrolyte composition may be achieved by a casting method, a coating method, a soaking method, a loading method, etc.

In the case of the coating method, the charge transfer layer may be formed by the steps of: preparing the uniform electrolyte composition comprising the electrolyte, additives such as a coating quality-improving agent (a leveling agent, etc.), etc.; coating the composition by a spin coating method, a dip coating method, an air-knife coating method, a curtain coating method, a roller coating method, a wire-bar coating method, a gravure coating method, an extrusion coating method using a hopper described in United States Patent No. 2,681,294, a simultaneous multi-layer coating method described in United States Patent Nos. 2,761,418, 3,508,947 and 2,761,791, etc.; and heating the coated composition, if necessary.

According to the preferable embodiment of the present invention, the electrolyte composition is coated in a more amount than that required to completely fulfill voids in the photosensitive layer. Therefore, as shown in Fig. 1, the resulting electrolyte composition layer substantially exists from the surface of the electrically conductive layer 10 to the surface of the counter electrically conductive layer 40. If the charge transfer layer 30 is defined as the electrolyte composition layer existing from the surface of the photosensitive layer 20 to the surface of the counter electrically conductive layer 40, the thickness of the charge transfer layer 30 is preferably 0.001 to 200 µm, more preferably 0.1 to 100 µm, particularly preferably 0.1 to 50 µm. When the charge transfer layer 30 has thickness of less than 0.001 µm, there is a fear that the semiconductor fine particles 21 in the photosensitive layer 20 comes in contact with the counter electrically conductive layer 40. On the other hand, when the thickness is more than 200 µm, the charge transfer distance becomes so large that the resistance of the device is increased. Incidentally, the total thickness of the photosensitive layer 20 and the charge transfer layer 30, which is substantially equal to the thickness of the electrolyte composition layer, is preferably 0.1 to 300 µm, more preferably 1 to 130 µm, particularly preferably 2 to 75 µm.

The counter electrode may be laminated on the photosensitive layer before providing the charge transfer layer, and the electrolyte composition may be spread into the voids therebetween by: a normal pressure method utilizing a capillarity; or a reduced pressure method which comprises pumping up the electrolyte composition from the open-end between the counter electrode and the photosensitive layer.

The charge transfer layer may be directly disposed on the photosensitive layer by the steps of: applying the electrolyte composition to the photosensitive layer; disposing the counter electrode on the applied electrolyte composition before drying it; and subjecting the edges thereof to a leakage-preventing treatment. Further, the gel charge transfer layer may be disposed by the steps of: wet-coating the electrolyte composition on the photosensitive layer; and gelling (solidifying) the coated electrolyte composition by polymerization, etc. After gelling, the counter electrode may be disposed on the gel charge transfer layer.

In the case where the molten salt is solid at room temperature, approximately 25 °C, it may be used as the electrolyte solution by adding a little amount of a solvent or an additive thereto. Alternatively, the molten salt may be incorporated in the photoelectric conversion device without the solvent and the additive by: a method where the molten salt penetrates onto the electrode by heat-dissolution; a method comprising the steps of dissolving the molten salt in a low boiling solvent such as methanol, acetonitrile and methylene chloride, making the resultant solution penetrate onto the electrode, and evaporating the solvent by heating; etc.

The charge transfer layer using the solid electrolyte or the solid hole-transporting material may be provided by a dry film-forming method such as a vacuum deposition method and a CVD method, and followed by applying the counter electrode thereon. The organic hole-transporting materials may be introduced into the electrodes by a vacuum deposition method, a casting method, a coating method, a spin-coating method, a soaking method, an electrolytic polymerization method, a photo electrolytic polymerization method, etc. The inorganic solid compound may also be introduced into the electrode by a casting method, a coating method, a spin-coating method, a soaking method, an electrolytic metal plating method, etc.

In the case of using an electrolyte composition that cannot be solidified such as the electrolysis solution and a wet hole-transporting material, it is preferable that the edges of the charge transfer layer is sealed immediately after coating the electrolyte composition, from the viewpoint of mass-production of the photoelectric conversion device. On the other hand, in the case of using an electrolyte composition that can be solidified, it is preferable that the electrolyte composition is wet-coated on the photosensitive layer, and then solidified by photo-polymerization, thermal radical polymerization, etc. Incidentally, the water-content of the charge transfer layer is preferably 10,000 ppm or less, more preferably 2,000 ppm or less, and particularly preferably 100 ppm or less.

### (B) Conductive Support

The conductive support is: (1) a single layer of the electrically conductive layer; or (2) two layers of the electrically conductive layer and the substrate. The substrate is not necessary in the case where the electrically conductive layer has a high strength and can sufficiently seal the photoelectric conversion device.

In the case of (1), the electrically conductive layer is preferably made of a material having a sufficient strength and electrical conductivity such as a metal, etc.

In the case of (2), as the conductive support may be used the substrate on which the electrically conductive layer containing an electrically conductive material is disposed at the photosensitive layer side. Preferable examples of the electrically conductive material include: metals such as platinum, gold, silver, copper, aluminum, rhodium and indium; carbon; electrically conductive metal oxides such as indium-tin composite oxides and tin oxides doped with fluorine; etc. The electrically conductive layer preferably has a thickness of 0.02 to 10 µm.

The surface resistance of the conductive support is preferably as low as possible. The surface resistance is preferably 100 Ω/square or less, more preferably 40 Ω/square or less. The lowest limit thereof is generally approximately 0.1 Ω/square, not limited in particular.

When light is irradiated from the conductive support side, it is preferred that the conductive support is substantially transparent. Herein, the term "substantially transparent" means light transmittance is 10 % or more. The light transmittance of the conductive support is more preferably 50 % or more, particularly preferably 70 % or more.

The transparent conductive support is preferably constituted by forming the transparent electrically conductive layer of an electrically conductive metal oxide on the transparent substrate of such material as a glass and a plastic by coating or vapor deposition. In particular, preferred is such that is made of a low-cost soda-lime float glass, on which the electrically conductive layer of tin oxide doped with fluorine is deposited. To obtain a low-cost and flexible photoelectrical conductive device or solar cell, a transparent polymer film disposed the electrically conductive layer thereon is preferably used as the transparent conductive support. As the materials for the transparent polymer film, tetracetylcellulose (TAC), polyethylene terephthalate (PET), polyethylene naphthalate (PEN), syndiotactic polystyrene (SPS), polyphenylenesulfide (PPS), polycarbonate (PC), polyarylate (PAr), polysulfone (PSF), polyestersulfone (PES), polyetherimide (PEI), cyclic polyolefin, brominated phenoxy, etc. may be used. To secure a sufficient transparency, the coating amount of the electrically conductive metal oxide is preferably 0.01 to 100 g per 1 m² of the glass or plastic substrate.

It is preferable that a metal lead is used to reduce a resistance of the transparent conductive support. Material for the metal lead is preferably aluminum, copper, silver, gold, platinum, nickel, etc., particularly preferably aluminum or silver. It is preferable that the metal lead is disposed on the transparent substrate by a vapor deposition method, a sputtering method, etc., the transparent electrically conductive layer of tin oxide doped with fluorine, or an ITO film being formed thereon. It is also preferable that the metal lead is disposed on the electrically conductive layer after forming the layer on the transparent substrate. The reduction in incident light quantity owing to the metal lead is suppressed to preferably 10 % or less, more preferably 1 to 5 %.

### (C) Photosensitive Layer

The photosensitive layer preferably contains semiconductor fine particles sensitized by a dye. The semiconductor in the photosensitive layer act as a so-called "photosensitive substance" to absorb light and conduct charge separation, thereby generating electrons and positive holes. With respect to the dye-sensitized semiconductor fine particles, the light-absorption and the generation of electrons and positive holes are primarily caused in the dye, and the semiconductor fine particles receive and convey the electrons.

### (1) Semiconductor

Used as the semiconductor may be: simple semiconductors such as silicone and germanium; III-V series compound semiconductors; metal chalcogenides such as oxides, sulfides and selenides; compounds with a perovskite structure such as strontium titanate, calcium titanate, sodium titanate, barium titanate and potassium niobate; etc. The semiconductor is preferably metal chalcogenide.

Preferable examples of the metal chalcogenide include: oxide of titanium, tin, zinc, iron, tungsten, zirconium, hafnium, strontium, indium, cerium, yttrium, lanthanum, vanadium, niobium or tantalum; sulfide of cadmium, zinc, lead, silver, antimony or bismuth; selenide of cadmium or lead; and cadmium telluride; etc. Additionally, the other compound semiconductors such as phosphide of zinc, gallium, indium or cadmium, selenide of gallium-arsenic or copper-indium, copper-indium sulfide, etc. may be used in this invention.

Preferable specific examples of the semiconductor used in the present invention include Si, TiO₂, SnO₂, Fe₂O₃, WO₃, ZnO, Nb₂O₅, CdS, ZnS, PbS, Bi₂S₃, CdSe, CdTe, GaP, InP, GaAs, CuInS₂ and CuInSe₂. Of these semiconductors, more preferred are TiO₂, ZnO, SnO₂, Fe₂O₃, WO₃, Nb₂O₅, CdS, PdS, CdSe, InP, GaAs, CuInS₂ and CuInSe₂, particularly preferred are TiO₂ and Nb₂O₅, and the most preferred is TiO₂.

The semiconductor may have a single crystal or poly crystal structure. The single crystal semiconductor is preferred from a viewpoint of a conversion efficiency, while the poly crystal semiconductor is preferred from viewpoints of a production cost, security of raw materials, an energy-payback time, etc.

The particle size of the semiconductor fine particles is generally in the nm to µm level. The mean size of primary particles, which is obtained from a diameter of a circle equivalent to a projected area, is preferably 5 to 200 nm, more preferably 8 to 100 nm. Further, the mean size of the secondary semiconductor particles in dispersion is preferably 0.01 to 100 µm. Two or more kinds of particles having a different particle size distribution may be mixed to use in the photosensitive layer. In this case, the average particle size of the smaller particles is preferably 5 nm or less. To improve a light-capturing rate of the photoelectric conversion device by scattering ray of light, the semiconductor fine particles having a large particle size, e.g. approximately 300 nm in diameter, may be added to the mixture composing the semiconductor layer.

Preferred as a method for producing the semiconductor fine particles are: sol-gel methods described in Sumio Sakka, "Science of Sol-Gel Method", Agune Shofusha (1998), Technical information Association, "Thin Film-Coating Technology By Sol-Gel Method" (1995), etc.; and gel-sol methods described in Tadao Sugimoto, "Synthesis of Mono-Dispersion Particles and Control of Their Size and Form by Novel Gel-Sol Method", and MATERIA, Vol. 35, No. 9, Page 1012 to 1018 (1996). The method developed by Degussa Company, which comprises preparing oxides by subjecting chlorides to a high temperature hydrolysis in an oxyhydrogen salt, is also preferred.

In the case where titanium oxide is used as the semiconductor fine particles, any of the above-described sol-gel methods, gel-sol methods and high temperature hydrolysis method are preferably used, further, a sulfuric acid method and a chlorine method described in Manabu Seino, "Titanium oxide - Properties and Applied Technique", Gihodo Shuppan, (1997) may be used. Of the sol-gel methods, also preferred are such that described in Christophe J. Barb'e, et al, Journal of American Ceramic Society, Vol. 80, No. 12, Page 3157 to 3171 (1997) and Burnside, et al, Chemical Materials, Vol. 10, No. 9, Page 2419 to 2425.

### (2) Semiconductor Fine Particle Layer

The semiconductor fine particles may be coated on the conductive support by: a method where dispersion or colloid solution containing the particles is applied on the electrically conductive layer; the above-mentioned sol-gel method; etc. A wet type film production method is relatively advantageous for the mass production of the photoelectric conversion device, improvement of properties of semiconductor fine particle solution and adaptability of the conductive support, etc. As such a wet type film production method, a coating method and a printing method are typical examples.

As a method for preparing the dispersion containing the semiconductor fine particles, the sol-gel method mentioned above may be used. Further, the dispersion may be prepared by crushing the semiconductor in a mortar, dispersing the semiconductor while grinding in a mill, or precipitating the semiconductor fine particles in a solvent when the semiconductor is synthesized.

As a dispersion solvent, water or organic solvents such as methanol, ethanol, isopropyl alcohol, dichloromethane, acetone, acetonitrile, ethyl acetate, etc. may be used. A polymer, a surfactant, an acid, a chelating agent, etc. may be used as a dispersing agent, if necessary.

Preferred coating methods are: a roller method and a dip method as an application series; an air-knife method and a blade method as a metering series; etc. Further, preferable as a method where an application and metering can be performed at the same time are a wire-bar method disclosed in JP-B-58-4589, a slide-hopper method described in United States Patent Nos. 2,681,294, 2,761,419, 2,761,791, etc., an extrusion method, a curtain method, etc. Furthermore, as for a wide use, a spin method and a spray method are preferred. As a wet type printing method, three major printing methods of a relief printing, an offset printing and a gravure printing, an intaglio printing, a gum printing, a screen printing, etc. are preferred. A preferable film production method may be selected from these methods in accordance with viscosity of the solution and a wet thickness.

The viscosity of the dispersion materially depends on the kind and dispersion property of the semiconductor fine particles, the kind of solvent and additives such as a surfactant and a binder. For a high viscosity dispersion (e.g. 0.01 to 500 Poise), an extrusion method, a cast method, a screen printing method, etc. are preferably used. On the other hand, for a low viscosity dispersion (e.g. 0.1 Poise or less), a slide-hopper method, a wire-bar method and a spin method are preferably used to form a uniform film. An extrusion method may be used for the low viscosity dispersion if it is coated to some extent. A wet type film production method may be properly selected in accordance with the viscosity of the coating solution, the coating amount, the support, a coating speed and so on.

The semiconductor fine particle layer is not limited to a single layer. The dispersions each comprising the semiconductor fine particles having a different particle size may be subjected to a multi-layer coating. Further, the dispersions each containing different kinds of semiconductor fine particles, binder, or additives may be subjected to a multi-layer coating. A multi-layer coating is also effectively used when a film thickness is insufficient by coating of once. Suitable for the multi-layer coating are an extrusion method and a slide-hopper method. When a multi-layer coating is carried out, a plurality of layers may be coated at the same time, or alternatively one over the other from several times to ten-several times. In the latter case, a screen method is also preferably used.

Generally, when the thickness of the semiconductor fine particle layer, which is equal to the thickness of the photosensitive layer, becomes thicker, the amount of the dye incorporated therein per unit of the projected area increases, thereby making the light capturing rate higher. However, because a diffusion distance of the generated electrons is increased in this case, loss owing to recombination of electric charges is also increased. Consequently, a preferable thickness of the semiconductor fine particle layer is 0.1 to 100 µm. When the semiconductor fine particle layer is used for the photo-electrochemical cell, the thickness thereof is preferably 1 to 30 µm, more preferably 2 to 25 µm. A coating amount of the semiconductor fine particles per 1 m² of the support is preferably 0.5 to 400 g, more preferably 5 to 100 g.

After coating the semiconductor fine particles on the conductive support, the particles are preferably subjected to a heat treatment to electronically contact them with each other, and to increase a coating strength and an adherence thereof with the support. A heating temperature is preferably 40 °C or more but less than 700 °C, more preferably 100 to 600 °C. A heating time is approximately 10 minutes to 10 hours. It is not preferred that a support having a low melting point or softening point such as a polymer film is subjected to a high temperature treatment because such a support tends to be deteriorated thereby. The heat treatment is preferably carried out at a temperature as low as possible also from a viewpoint of cost. The practice at such a low temperature is realized by a combination use with the above-described small semiconductor fine particles having a size of 5 nm or less, a heat treatment in the presence of a mineral acid, etc.

After a heat treatment, a chemical metal-plating using an titanium tetrachloride aqueous solution, etc. or an electrochemical metal-plating using an titanium trichloride aqueous solution may be carried out to increase a surface area of the semiconductor fine particles, or to enhance a purity in the vicinity of the particles, thereby improving an electron injection efficiency into the particles from the dye.

It is preferable that the semiconductor fine particles have a large surface area to adsorb lots of dyes. Therefore, the surface area in the state that the semiconductor fine particle layer is coated on the support is preferably 10 times or more, more preferably 100 times or more of the projected area. The highest limit, even though it is not limited in particular, is generally a level of 1000 times.

### (3) Dye

The dye used for the photosensitive layer in the present invention is preferably a metal complex dye, a phthalocyanine dye and/or a methine dye, more preferably a metal complex dye and/or a polymethine dye. Two or more kinds of dyes may be used as a mixture to obtain a large photoelectric conversion wavelength region and a high photoelectric conversion efficiency. In the case of using a plurality of the dyes, the kinds and mixing ratio of the dyes may be selected in accordance with the wavelength region and the strength distribution of the light source.

The dye preferably has an appropriate interlocking group for interacting with the surface of the semiconductor. Preferred interlocking groups include -COOH, -OH, -SO₃H, a cyano group, -P(O)(OH)₂, -OP(O)(OH)₂, and π-conductive chelating groups such as oxime, dioxime, hydroxyquinoline, salicylate and α-ketoenolate groups. Among them, particularly preferred are -COOH, -P(O)(OH)₂ and -OP(O)(OH)₂. The interlocking group may form a salt with an alkaline metal, etc. or an intramolecular salt. If the methine chain of the polymethine dye has an acidic group in such a case where the methine chain forms squarylium ring or croconium ring, it may act as the interlocking group.

The preferred dyes used for the photosensitive layer will be specifically described below.

### (a) Metal Complex Dye

The metal atom of the metal complex dye used in the present invention is preferably ruthenium atom. The ruthenium complex dyes described in United States Patent Nos. 4,927,721, 4,684,537, 5,084,365, 5,350,644, 5,463,057, 5,525,440, Japanese Patent Laid-Open No. 7-249790, JP-B-10-504512, WO 98/50393, etc. may be used in the present invention.

The ruthenium complex dye used in the present invention is preferably represented by the following formula (I):

(A₁)ₚRu(B-a)(B-b)(B-c) (I)

wherein A₁ represents a ligand selected from the group consisting of Cl, SCN, H₂O, Br, I, CN, NCO and SeCN; *p* is an integer of 0 to 3, preferably 2; and B-a, B-b, and B-c independently represent an organic ligand represented by any of the following formulae B-1 to B-10. 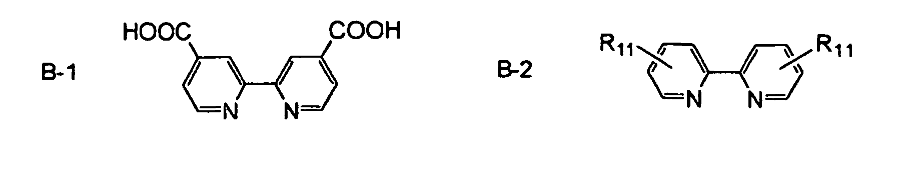 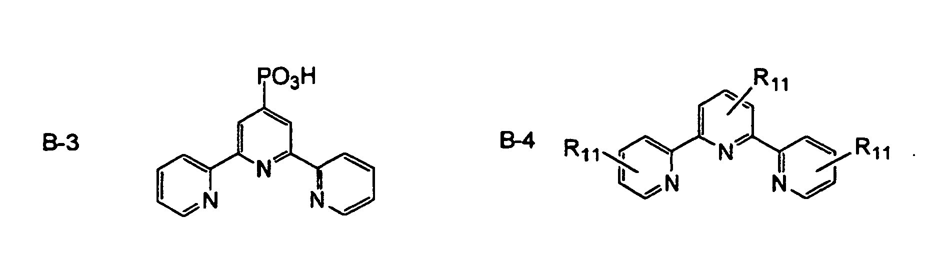 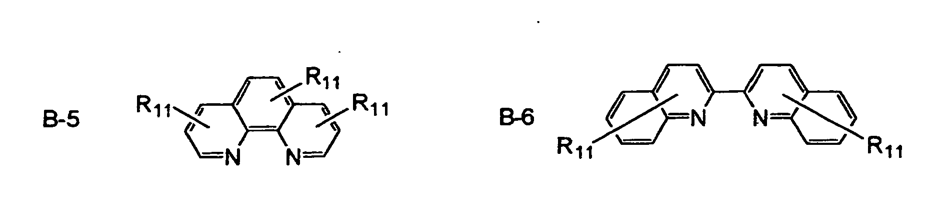 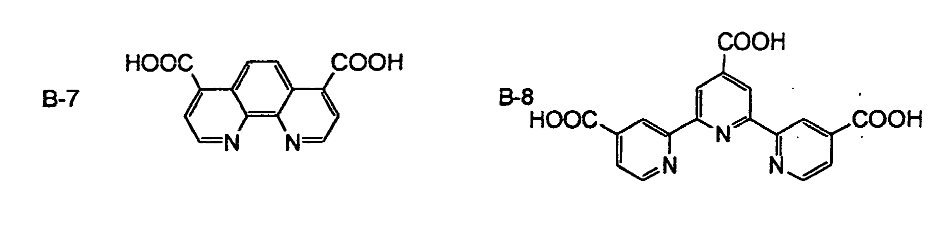 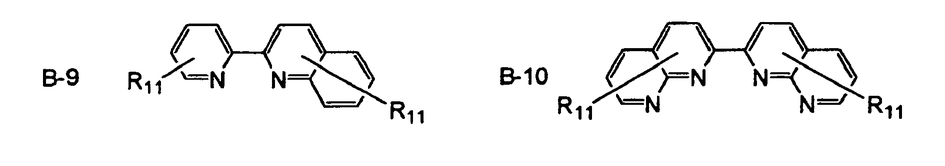 In the formulae B-1 to B-10, R₁₁ represents a substituent. Specific examples thereof include: a halogen atom; a substituted or unsubstituted alkyl group having 1 to 12 carbon atom; a substituted or unsubstituted aralkyl group having 7 to 12 carbon atoms; a substituted or unsubstituted aryl group having 6 to 12 carbon atoms; an acidic group that may form a salt such as a carboxyl group and a phosphono group; etc. The alkyl group and the alkyl moiety of the aralkyl group may be straight or branched, and the aryl group and the aryl moiety of the aralkyl group may have a monocyclic structure or a polycyclic structure such as a condensed ring and a ring assemblage. B-a, B-b and B-c may be the same or different ligands.

The metal complex dyes preferably usable in the present invention will be illustrated below without intention of restricting the scope of the present invention defined by the claims attached hereto.

(A₁)ₚRu(B-a)(B-b)(B-c) (I)

| | A₁ | p | B-a | B-b | B-c | R₁₁ |
|---|---|---|---|---|---|---|
| R-1 | SCN | 2 | B-1 | B-1 | ― | ― |
| R-2 | CN | 2 | B-1 | B-1 | ― | ― |
| R-3 | Cl | 2 | B-1 | B-1 | ― | ― |
| R-4 | CN | 2 | B-7 | B-7 | ― | ― |
| R-5 | SCN | 2 | B-7 | B-7 | ― | ― |
| R-6 | SCN | 2 | B-1 | B-2 | ― | H |
| R-7 | SCN | 1 | B-1 | B-3 | ― | ― |
| R-8 | Cl | 1 | B-1 | B-4 | ― | H |
| R-9 | I | 2 | B-1 | B-5 | ― | H |
| R-10 | SCN | 3 | B-8 | ― | ― | ― |
| R-11 | CN | 3 | B-8 | ― | ― | ― |
| R-12 | SCN | 1 | B-2 | B-8 | ― | H |
| R-13 | ― | 0 | B-1 | B-1 | B-1 | ― |

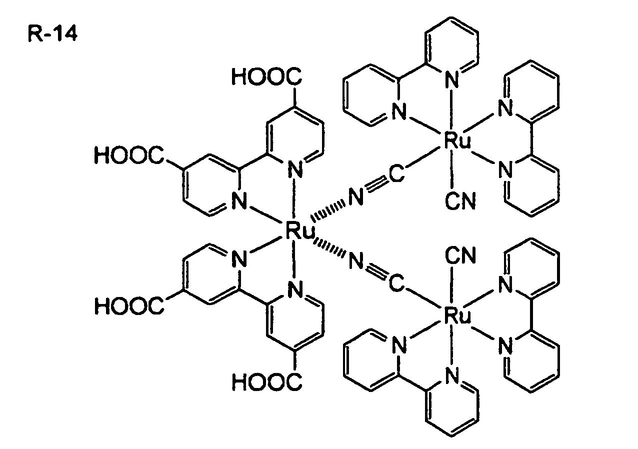

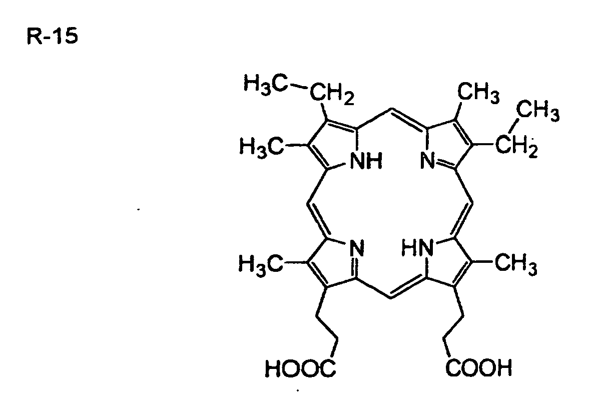

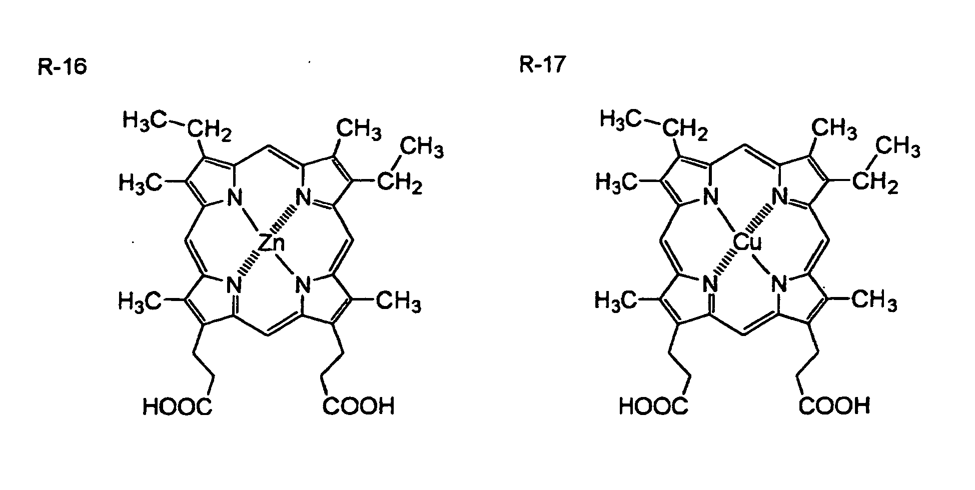

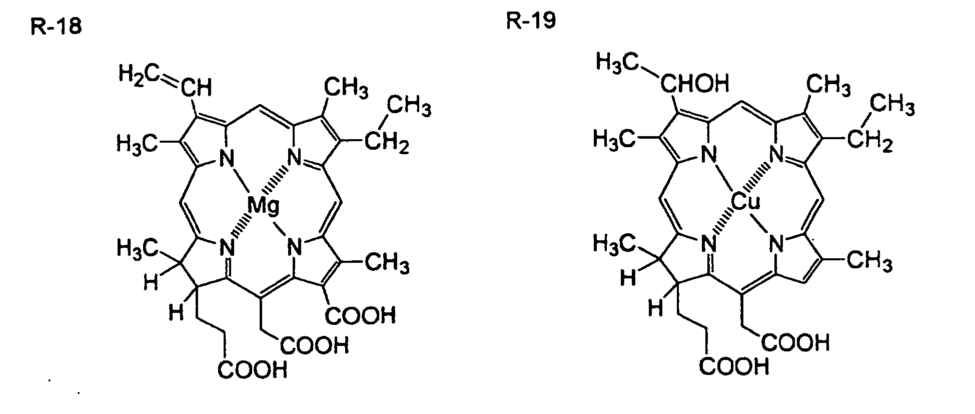

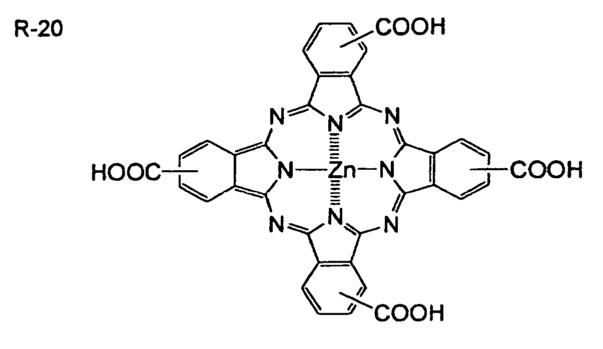

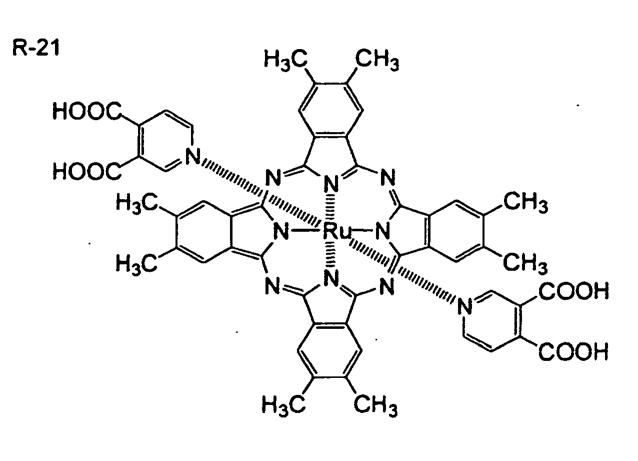

### (b) Methine Dye

The methine dyes used in the present invention are preferably represented by any of the following general formulae (II), (III), (IV) and (V).

### 1. General Formula (II)

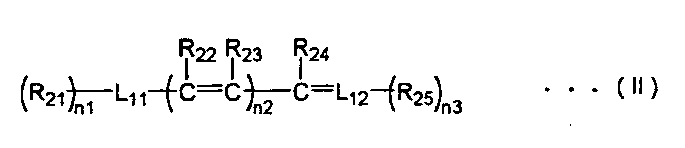

In the general formula (II), R₂₁ and R₂₅ independently represent a hydrogen atom, an alkyl group, an aryl group or a heterocyclic group; R₂₂ to R₂₄ independently represent a hydrogen atom or a substituent; R₂₁ to R₂₅ may be bonded together to form a ring; L₁₁ and L₁₂ independently represent a nitrogen atom, an oxygen atom, a sulfur atom, a selenium atom or a tellurium atom; n1 and n3 independently represent an integer of 0 to 2; and n2 represents an integer of 1 to 6. This dye may have a counter ion in agreement with the charge quantity of the whole molecule.

The above-mentioned alkyl group, aryl group and heterocyclic group may have a substituent. The alkyl group may be a straight or branched, and the aryl group and the heterocyclic group may have a monocyclic structure or a polycyclic structure such as a condensed ring and a ring assemblage. Further, the ring formed by R₂₁ to R₂₅ may have a substituent, and may be a monocyclic ring or a condensed ring.

### 2. General Formula (III)

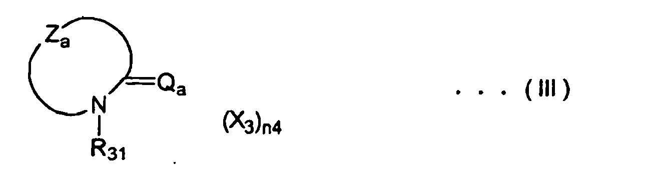

In the general formula (III), Zₐ represents a non-metal atomic group forming a nitrogen-containing heterocycle, and R₃₁ represents an alkyl group or an aryl group. Qₐ represents a methine group or a polymethine group necessary to act as a polymethine dye. The dye may form an oligomer or a polymer through Qₐ. X₃ represents a counter ion, and n4 indicating a number thereof represents an integer of 0 to 10.

The nitrogen-containing heterocycle formed by Zₐ may have a substituent, and may be a monocyclic ring or a condensed ring. The alkyl or aryl group represented by R₃₁ may have a substituent, the alkyl group may be a straight or branched, and the aryl group may have a monocyclic structure or a polycyclic structure such as a condensed ring and a ring assemblage.

Of the dyes represented by the general formula (III), more preferred are those represented by any of the following general formulae (III-a) to (III-d): 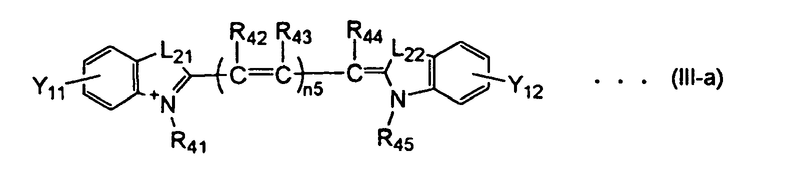 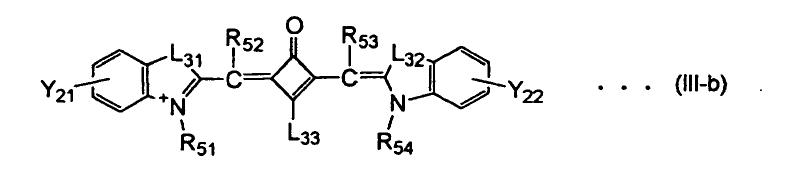 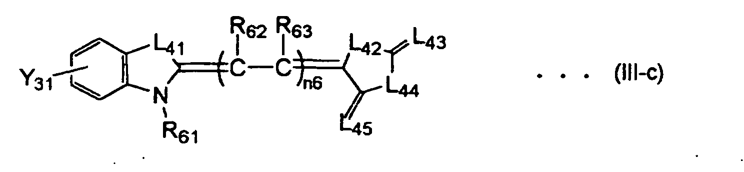 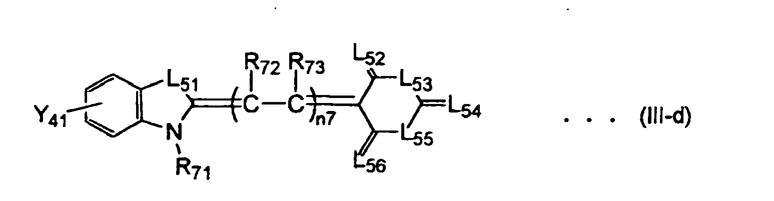 wherein R₄₁ to R₄₅, R₅₁ to R₅₄, R₆₁ to R₆₃ and R₇₁ to R₇₃ independently represent a hydrogen atom, an alkyl group, an aryl group or a heterocyclic group; L₂₁, L₂₂, L₃₁ L₃₂, L₄₁ to L₄₅ and L₅₁ to L₅₆ independently represent an oxygen atom, a sulfur atom, a selenium atom, a tellurium atom, -CRR'- or -NR- (in which R and R' independently represent a hydrogen atom, an alkyl group, an aryl group or a heterocyclic group, and may be the same or different); L₃₃ represents O⁻, S⁻, Se⁻, Te⁻ or NR (in which R represents a hydrogen atom, an alkyl group, an aryl group or a heterocyclic group); Y₁₁, Y₁₂, Y₂₁, Y₂₂, Y₃₁ and Y₄₁ independently represent a substituent; and n5, n6, and n7 independently represent an integer of 1 to 6.

The dyes represented by any one of the general formulae (III-a) to (III-d) may have a counter ion in agreement with the charge of the molecule. The alkyl group, the aryl group and the heterocyclic group mentioned above may have a substituent, the alkyl group may be straight or branched, and the aryl group and the heterocyclic group may have a monocyclic structure or a polycyclic structure such as a condensed ring and a ring assemblage.

Specific examples of the polymethine dyes represented by the general formula (III) are described in detail in M. Okawara, T. Kitao, T. Hirashima and M. Matsuoka, "Organic Colorants", Elsevier, etc.

### 3. General Formula (IV)

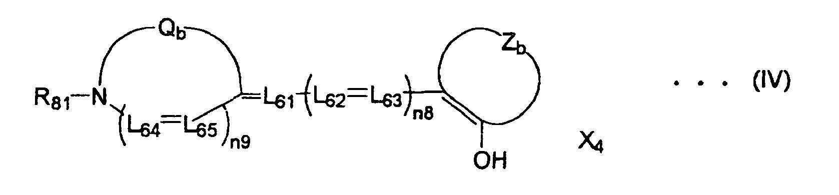

In the general formula (IV), Q_{b} represents an atomic group forming a 5-or 6-membered nitrogen-containing heterocycle; Z_{b} represents an atomic group forming a 3- to 9-membered ring; and L₆₁ to L₆₅ independently represent a substituted or unsubstituted methine group. n8 is an integer of 0 to 4, preferably an integer of 0 to 3, and n9 is 0 or 1. R₈₁ represents a substituent, and X₄ represents a counter ion contained if necessary to neutralize charge of the dye.

The nitrogen-containing heterocycle formed by Q_{b} may be a condensed ring, and may have a substituent. Preferable examples of the heterocycle include a benzothiazole ring, a benzoxazole ring, a benzoselenazole ring, a benzotellurazole ring, a 2-quinoline ring, a 4-quinoline ring, a benzoimidazole ring, a thiazoline ring, an indolenine ring, an oxadiazole ring, a thiazole ring and an imidazole ring. Of these, a benzothiazole ring, a benzoxazole ring, a benzoimidazole ring, a benzoselenazole ring, a 2-quinoline ring, a 4-quinoline ring and an indolenine ring are more preferred, a benzothiazole ring, a benzoxazole ring, a 2-quinoline ring, a 4-quinoline ring and an indolenine ring are particularly preferred.

Preferable examples of the substituent on Q_{b} include: a carboxyl group; a phosphonyl group; a sulfonyl group; halogen atoms such as F, Cl, Br and I; a cyano group; an alkoxy group such as a methoxy group, an ethoxy group and a methoxyethoxy group; an aryloxy group such as a phenoxy group; an alkyl group such as a methyl group, an ethyl group, a cyclopropyl group, a cyclohexyl group, a trifluoromethyl group, a methoxyethyl group, an allyl group and a benzyl group; an alkylthio group such as a methylthio group and an ethylthio group; an alkenyl group such as a vinyl group and a 1-propenyl group; an aryl group such as a phenyl group, a chlorophenyl group and toluyl group; a heterocyclic group such as a thienyl group; etc.

Z_{b} is preferably composed of atoms selected from the group consisting of carbon, oxygen, nitrogen, sulfur and hydrogen atoms. The ring formed by Z_{b} is preferably a ring with a 4 to 6 carbon skeleton, more preferably such that represented by any one of the following (a) to (e), the most preferably such that represented by (a).

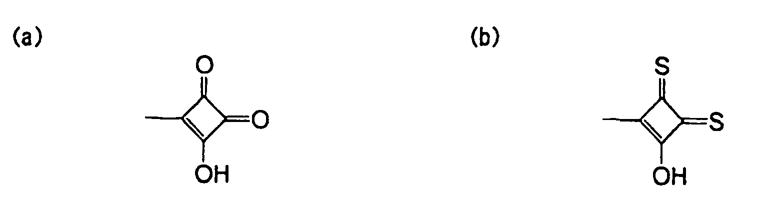

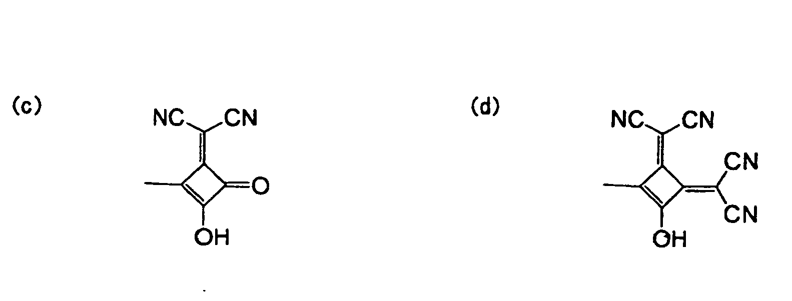

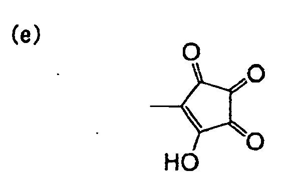

Examples of the substituent on L₆₁ to L₆₅ include: a substituted or unsubstituted alkyl group having preferably 1 to 12 carbon atom, more preferably 1 to 7 carbon atom, such as a methyl group, an ethyl group, a propyl group, an isopropyl group, a cyclopropyl group, a butyl group, a 2-carboxyethyl group and a benzyl group; a substituted or unsubstituted aryl group preferably having 6, 8 or 10 carbon atoms, more preferably 6 or 8 carbon atoms, such as a phenyl group, a tolyl group, a chlorophenyl group and an o-carboxyphenyl group; a heterocyclic group such as a pyridyl group, a thienyl group, a furanyl group and a barbituric acid group; a halogen atom such as a chlorine atom and a bromine atom; an alkoxy group such as a methoxy group and an ethoxy group; an amino group having preferably 1 to 12, more preferably 6 to 12 carbon atoms, such as a diphenylamino group, a methylphenylamino group and a 4-acetylpiperazine-1-yl group; an oxo group; etc. The substituents may be bonded together to form a cyclopentene ring, a cyclohexene ring, a squalilium ring, etc. Further, the substituents may combine an auxochrome to form a ring.

The substituent represented by R₈₁ is preferably an aliphatic group that may have a substituent or an aromatic group that may have a substituent. The aliphatic group has preferably 1 to 10, more preferably 1 to 6 carbon atom. The aromatic group has preferably 1 to 16 carbon atom, more preferably 5 or 6 carbon atoms. Examples of the unsubstituted aliphatic group and aromatic group include a methyl group, an ethyl group, a *n*-propyl group, a *n*-butyl group, a phenyl group and a naphthyl group.

Whether the dye is a cation or an anion, and whether it has the net ionic charge or not depends on the auxochrome and substituents thereof. The charge of the entire dye molecule is neutralized by a counter ion X₄. Typical positive counter ions are inorganic or organic ammonium ions such as a tetralkyl ammonium ion, a pyridinium ion, etc. and alkali metal ions. On the other hand, negative counter ions may be inorganic or organic, and examples thereof include: a halide ion such as a fluoride ion, a chloride ion, a bromide ion and an iodide ion; a substituted aryl sulfonate ion such as ap-toluene sulfonate ion and ap-chlorobenzene sulfonate ion; an aryl disulfonate ion such as a 1,3-benzene disulfonate ion, a 1,5-naphthalene disulfonate ion and a 2,6-naphthalene disulfonate ion; an alkyl sulfate ion such as a methyl sulfate ion; a sulfate ion; a thiocyanate ion; a perchlorate ion; a tetrafluoroborate ion; a picrate ion; an acetate ion; a trifluoromethane sulfonate ion; etc.

Further, ionic polymers or other dyes having an opposite charge to the dye may be also used as a charge-balancing counter ion. Alternatively, metal complex such as bisbenzene-1,2-dithiolato nickel (III) can be also used in the present invention.

### 4. General Formula (V)

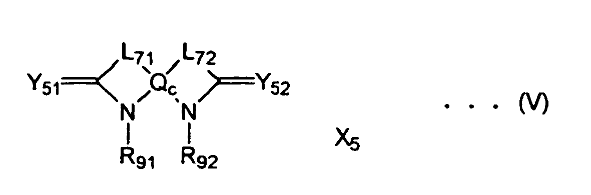

In the general formula (V), Q_{c} represents an at least tetravalent aromatic group; and L₇₁ and L₇₂ independently represent a sulfur atom, a selenium atom or -CRR'- (in which R and R' independently represent a hydrogen atom or an alkyl group, and may be the same or different group). L₇₁ and L₇₂ are preferably a sulfur atom or -CRR'-, more preferably -CRR'-, respectively. R₉₁ and R₉₂ independently represent an alkyl group or an aromatic group, and Y₅₁ and Y₅₂ independently represent a non-metal atomic group necessary to act as a polymethine dye. X₅ represents a counter ion.

Q_{c} may be derived from an aromatic hydrocarbon such as benzene, naphthalene, anthracene and phenanthrene, an aromatic heterocyclic ring such as anthraquinone, carbazole, pyridine, quinoline, thiophene, furan, xanthene and thianthrene, etc. The aromatic group Q_{c} may have a substituent. Q_{c} is derived from preferably aromatic hydrocarbon, more preferably benzene or naphthalene.

Various kinds of methine dyes can be formed by Y₅₁ and Y₅₂. It is preferable that Y₅₁ and Y₅₂ form a cyanine dye, a merocyanine dye, a rhodacyanine dye, a trinuclear merocyanine dye, an allopolar dye, a hemicyanine dye or a styryl dye. Herein, the cyanine dyes include such that having substituents that forms a squalium ring, a croconium ring, etc. on the methine chain. Details of the dyes represented by the general formula (V) are described in: F. M. Harmer, "Heterocyclic Compounds -Cyanine Dyes and Related Compounds", John Wiley & Sons, New York, London (1964); D. M. Sturmer, "Heterocyclic Compounds -Special Topics in Heterocyclic Chemistry", Chapter 18, Section 14, Page 482 to 515, John Wiley & Sons, New York, London (1977); etc. Among the cyanine dyes, the merocyanine dyes and the rhodacyanine dyes, preferred are such that described in United States Patent No. 5,340,694, Chapter (XI), (XII) and (XIII), Page 21 to 22. The dye represented by the general formula (V) has a squalilium ring on preferably at least one methine chain, more preferably the both methine chains.

R₉₁ and R₉₂ are independently an aliphatic group or an aromatic group, which may have a substituent. The aliphatic group has preferably 1 to 10 carbon atom, more preferably 1 to 6 carbon atom. The aromatic group has preferably 5 to 16 carbon atoms, more preferably 5 or 6 carbon atoms. Examples of the unsubstituted aliphatic group and aromatic group include a methyl group, an ethyl group, a *n*-propyl group, a *n*-butyl group, a phenyl group and a naphthyl group.

It is preferable that at least one of R₉₁, R₉₂, Y₅₁ and Y₅₂ has an acidic group. The acidic group is a group with a dissociative proton, such as a carboxylic acid group, a phosphonic acid group, a sulfonic acid group, a boric acid group, etc. Among them, preferred is a carboxylic acid group. The dissociative proton of the acidic group may be dissociated.

The specific examples (1) to (43) and S-1 to S-42 of the polymethine dyes represented by any of the general formulae (II) to (V) will be illustrated below without intention of restricting the scope of the present invention defined by the claims attached hereto.

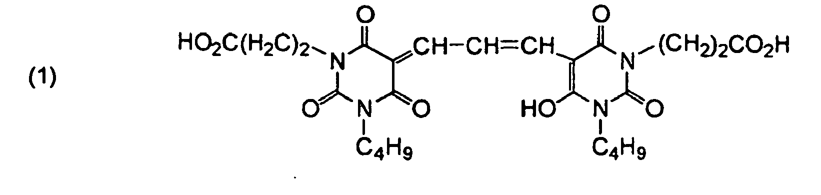

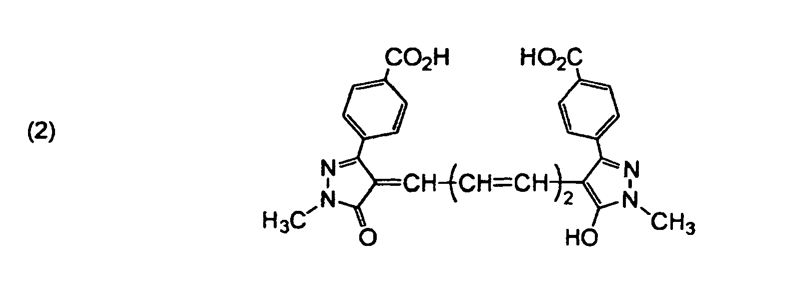

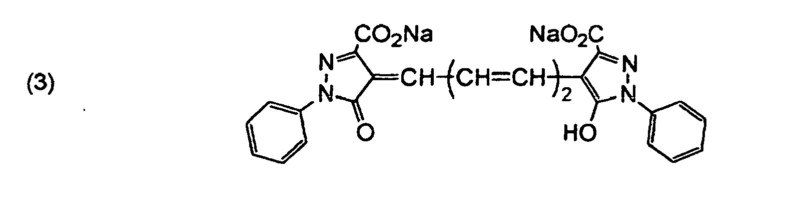

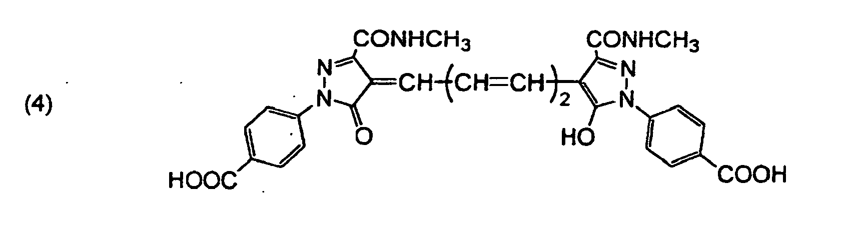

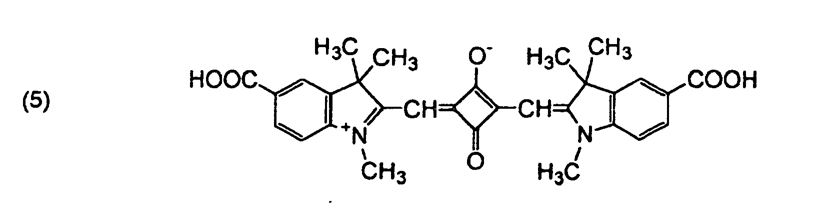

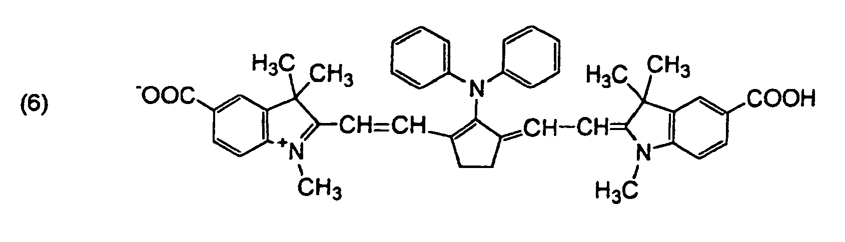

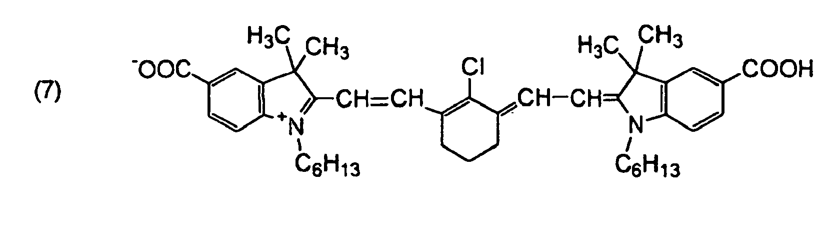

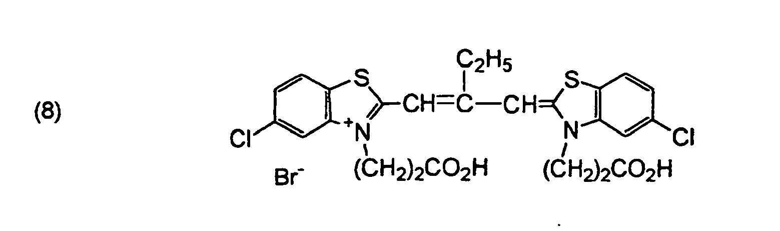

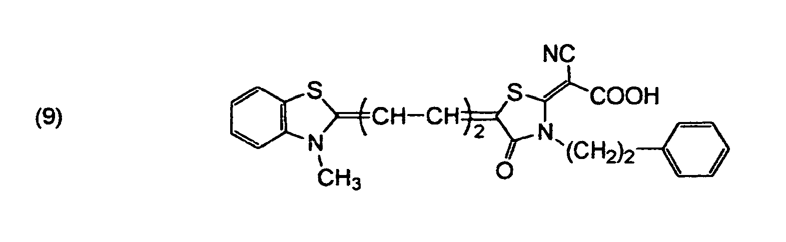

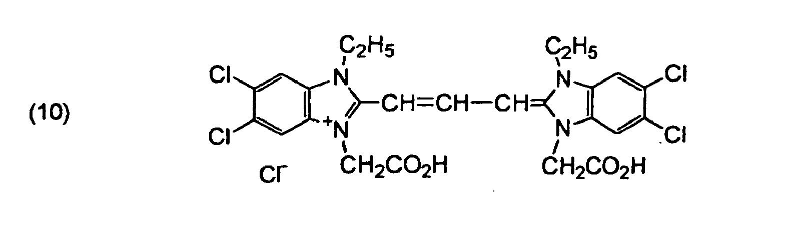

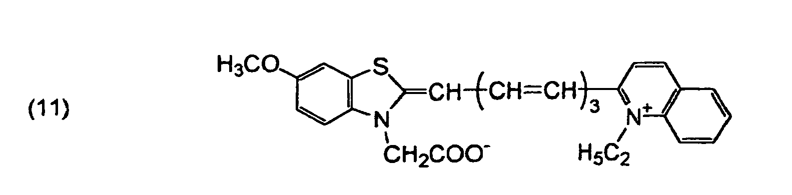

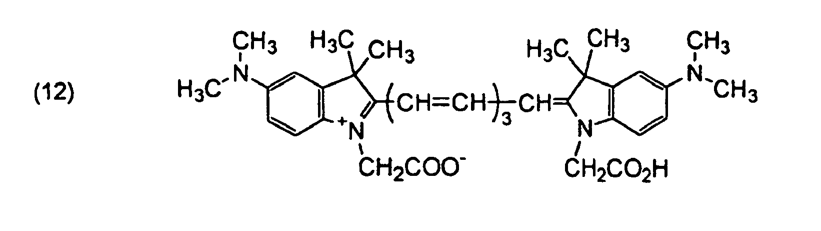

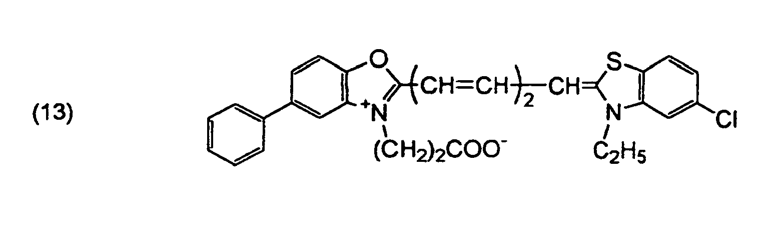

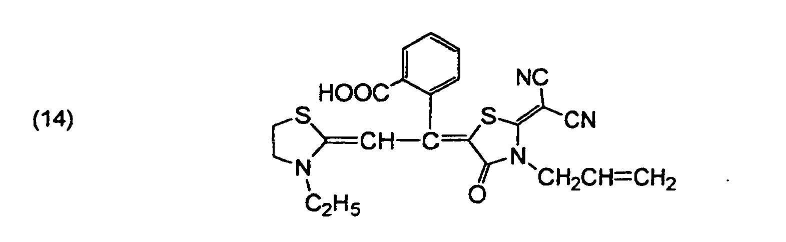

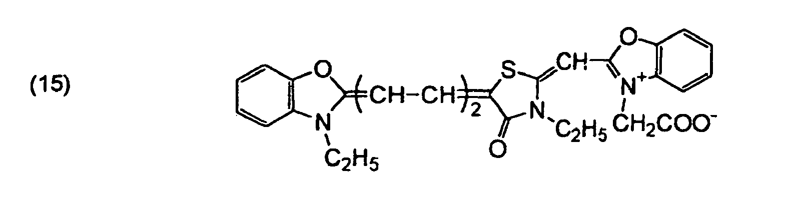

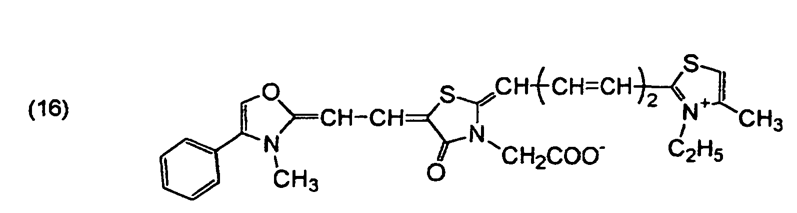

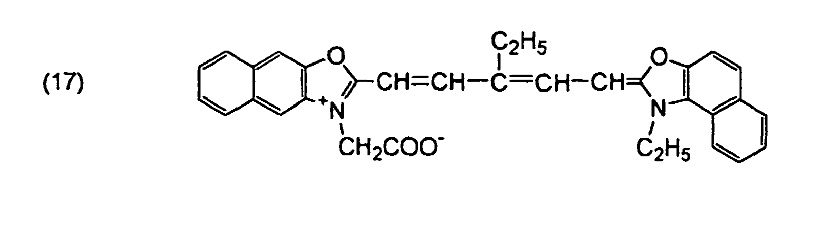

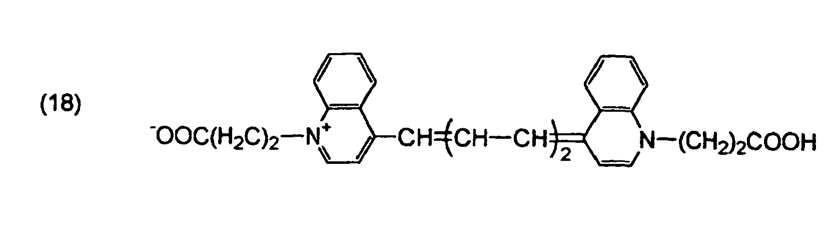

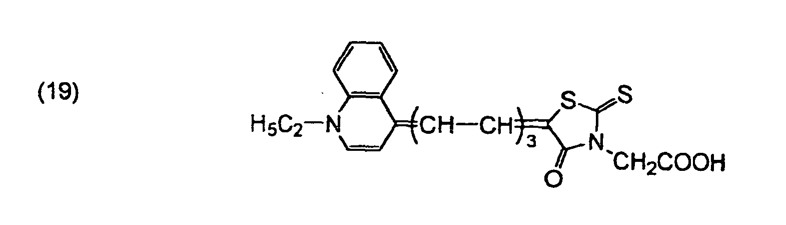

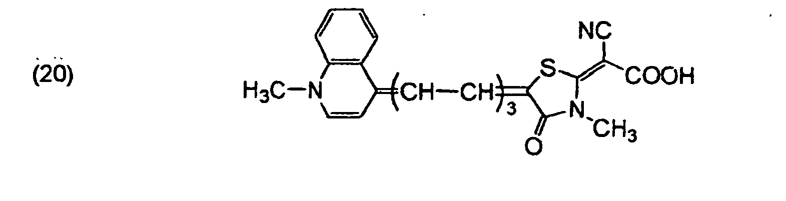

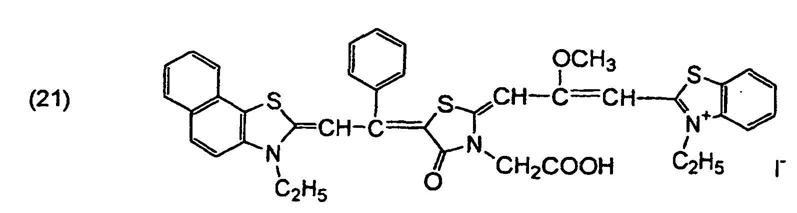

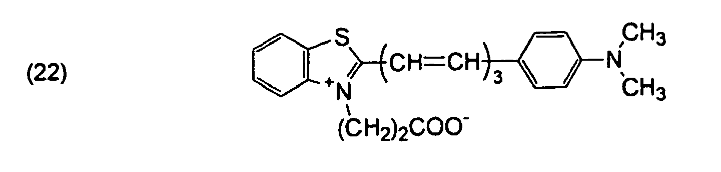

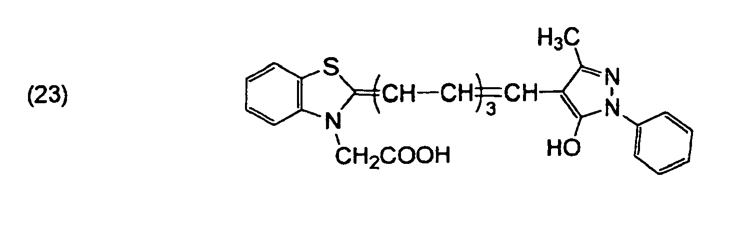

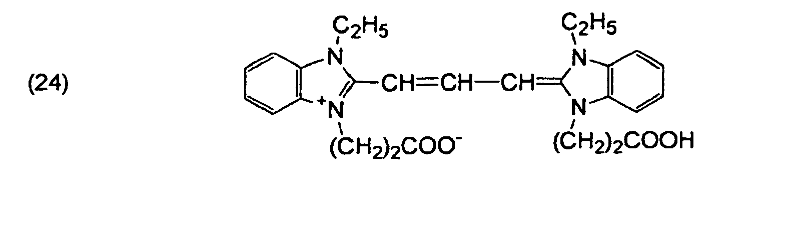

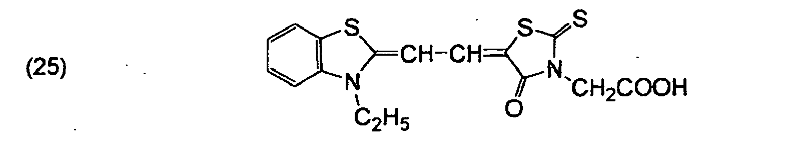

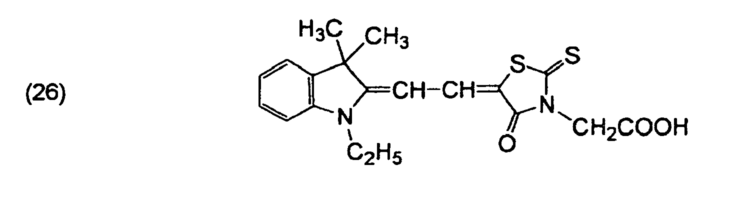

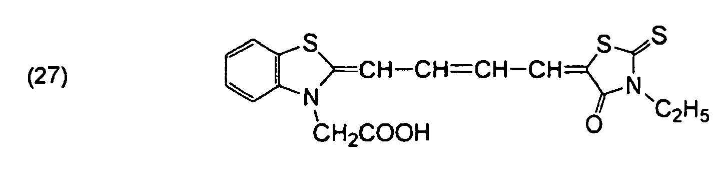

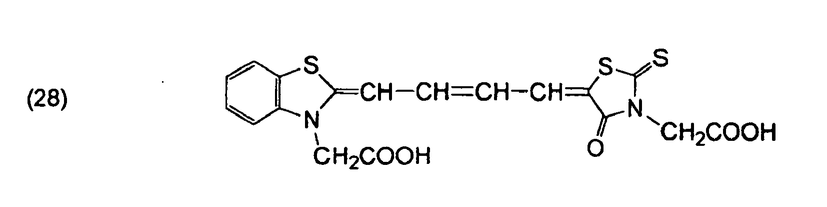

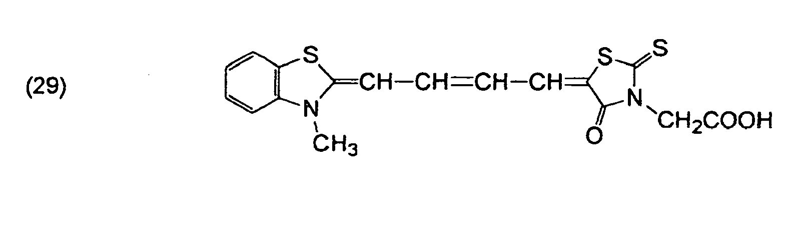

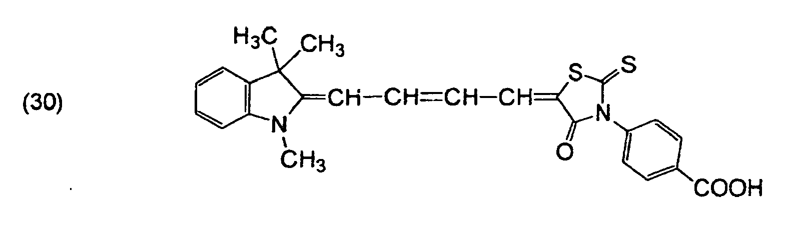

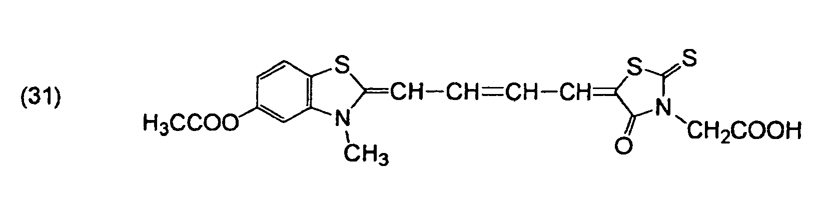

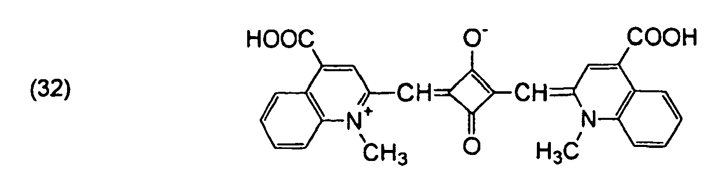

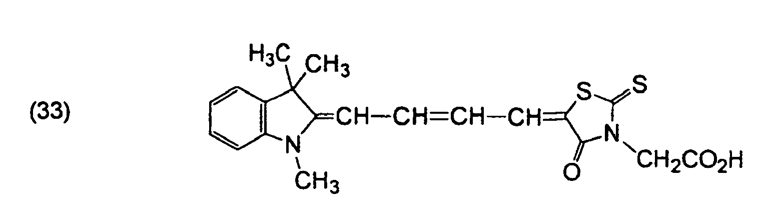

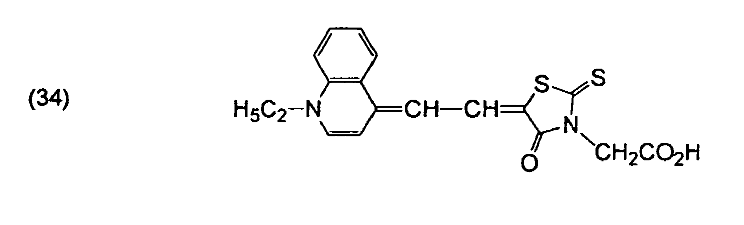

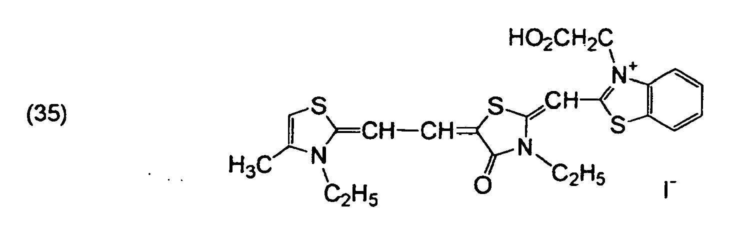

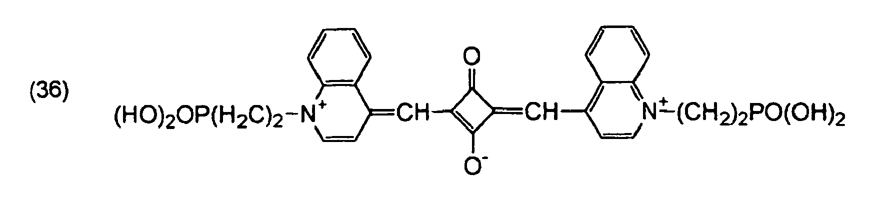

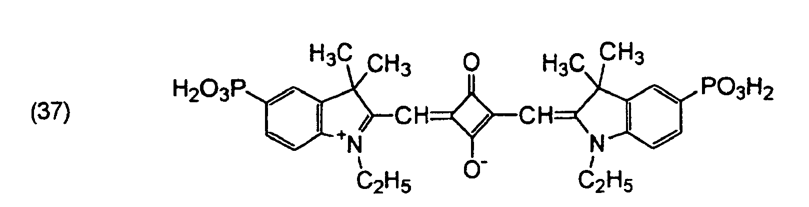

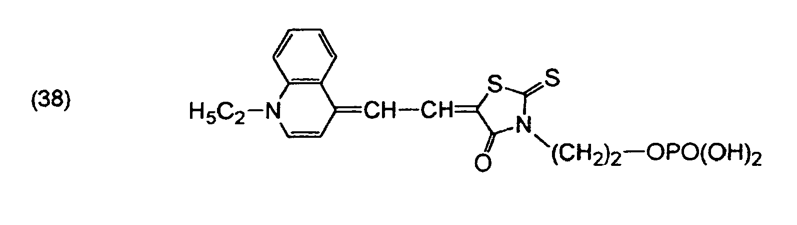

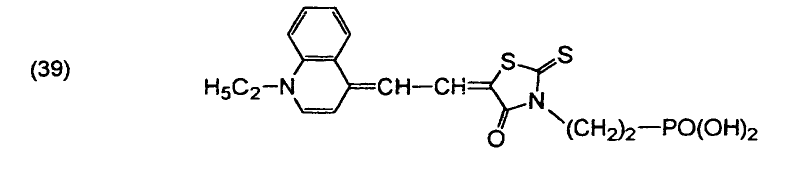

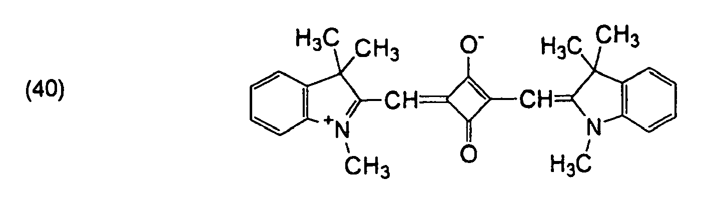

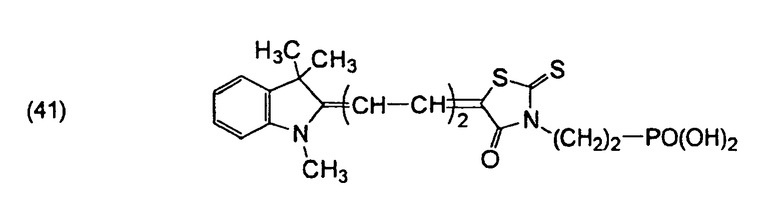

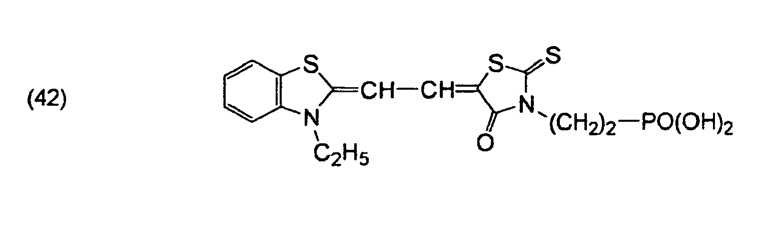

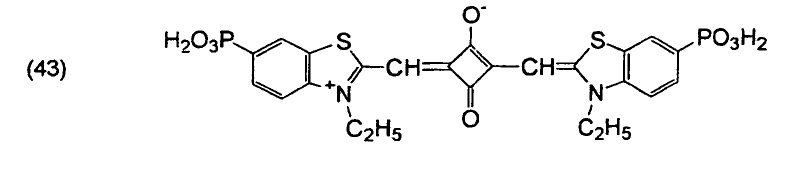

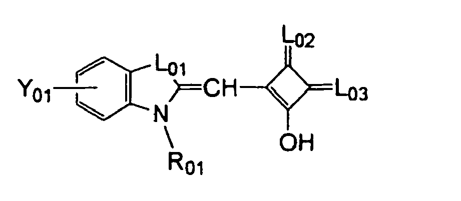

| Dye | Y₀₁ | R₀₁ | L₀₁ | L₀₂ | L₀₃ |
|---|---|---|---|---|---|
| S-1 | 4,5-Benzo | C₃H₇ | C(CH₃)₂ | O | O |
| S-2 | H | (CH₂)₃COOH | C(CH₃)₂ | O | O |
| S-3 | 4,5-Benzo | C₂H₅ | C(CH₃)₂ | S | S |
| S-4 | 4,5-Benzo | C₂H₅ | C(CH₃)₂ | C(CN)₂ | O |
| S-5 | 4,5-Benzo | C₂H₅ | C(CH₃)₂ | C(CN)₂ | C(CN)₂ |
| S-6 | H | C₂H₅ | S | O | O |
| S-7 | 5,6-Benzo | CH₃ | S | O | O |
| S-8 | H | CH₃ | O | O | O |
| S-9 | H | CH₃ | Se | O | O |
| S-10 | H | CH₃ | N(C₂H₅) | O | O |
| S-11 | H | C₂H₅ | -CH=CH- | O | O |
| 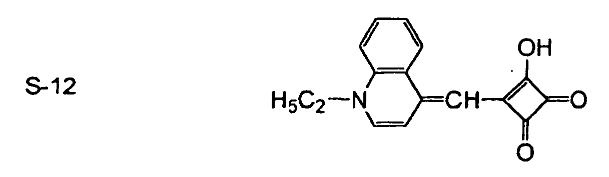 | | | | | |

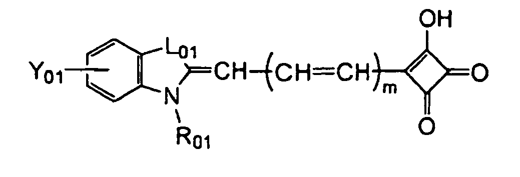

| Dye | Y₀₁ | R₀₁ | L₀₁ | m |
|---|---|---|---|---|
| S-13 | H | CH₃ | C(CH₃)₂ | 1 |
| S-14 | 4,5-Benzo | C₂H₅ | C(CH₃)₂ | 1 |
| S-15 | H | CH₃ | S | 2 |
| S-16 | 5,6-Benzo | C₂H₅ | S | 3 |
| S-17 | 5, 6-Benzo | C₂H₅ | S | 4 |
| S-18 | H | CH₃ | O | 1 |

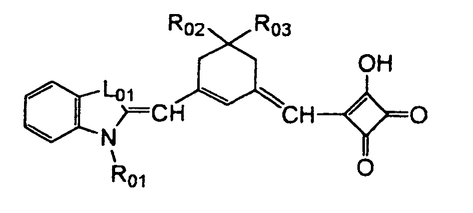

| Dye | R₀₁ | R₀₂ | R₀₃ | L₀₁ |
|---|---|---|---|---|
| S-19 | C₂H₅ | CH₃ | CH₃ | C(CH₃)₂ |
| S-20 | C₂H₅ | CH₃ | CH₃ | S |
| S-21 | (CH₂)₃COOH | CH₃ | CH₃ | O |
| S-22 | C₂H₅ | Ph | H | O |

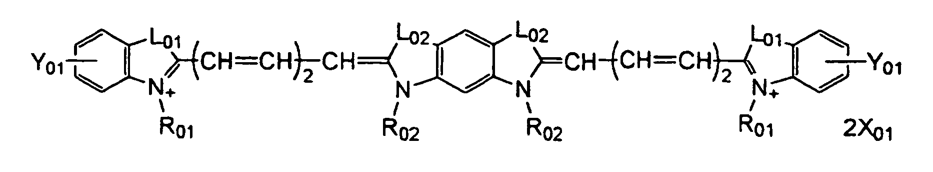

| Dye | Y₀₁ | R₀₁ | R₀₂ | L₀₁ | L₀₂ | X₀₁ |
|---|---|---|---|---|---|---|
| S-23 | H | CH₃ | CH₃ | S | S | I⁻ |
| S-24 | 5-COOH | C₂H₅ | CH₃ | S | S | I⁻ |
| S-25 | 5-COOH | CH₃ | CH₃ | C(CH₃)₂ | C(CH₃)₂ | I⁻ |
| S-26 | H | (CH₂)₂COOH | C₂H₅ | C(CH₃)₂ | C(CH₃)₂ | Cl⁻ |
| S-27 | H | CH₃ | C₂H₅ | C(CH₃)₂ | O | I⁻ |

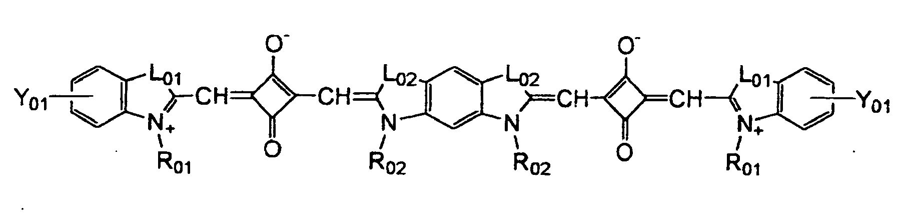

| Dye | Y₀₁ | R₀₁ | R₀₂ | L₀₁ | L₀₂ |
|---|---|---|---|---|---|
| S-28 | H | CH₃ | CH₃ | C(CH₃)₂ | S |
| S-29 | 4,5-Benzo | C₃H₇ | CH₃ | C(CH₃)₂ | S |
| S-30 | 5-COOH | CH₃ | CH₃ | S | C(CH₃)₂ |
| S-31 | 5-COOH | CH₃ | CH₃ | C(CH₃)₂ | C(CH₃)₂ |
| S-32 | 5-CH₃ | CH₃ | C₂H₅ | N(CH₃) | C(CH₃)₂ |

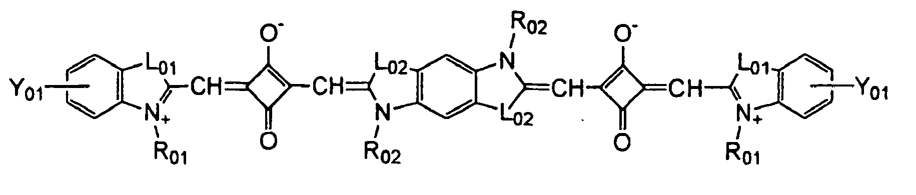

| Dye | Y₀₁ | R₀₁ | R₀₂ | L₀₁ | L₀₂ |
|---|---|---|---|---|---|
| S-33 | H | CH₃ | CH₃ | C(CH₃)₂ | S |
| S-34 | 5-SO₃H | C₂^{H}5 | CH₃ | C(CH₃)₂ | S |
| S-35 | 5-COOH | CH₃ | C₂H₅ | C(CH₃)₂ | C(CH₃)₂ |
| S-36 | 4,5-Benzo | (CH₂)₂COOH | CH₃ | C(CH₃)₂ | C(CH₃)₂ |
| S-37 | 5-CH₃ | CH₃ | C₂H₅ | NCH₃ | C(CH₃)₂ |

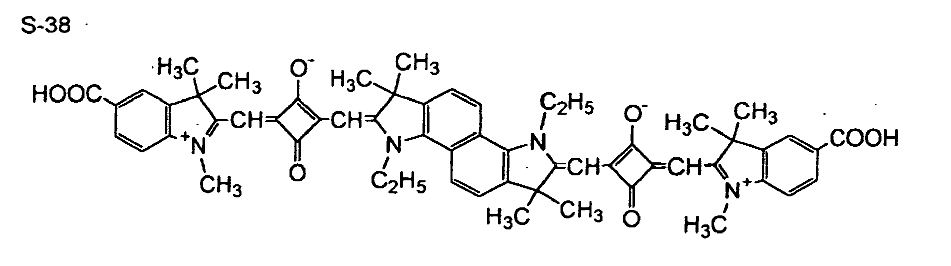

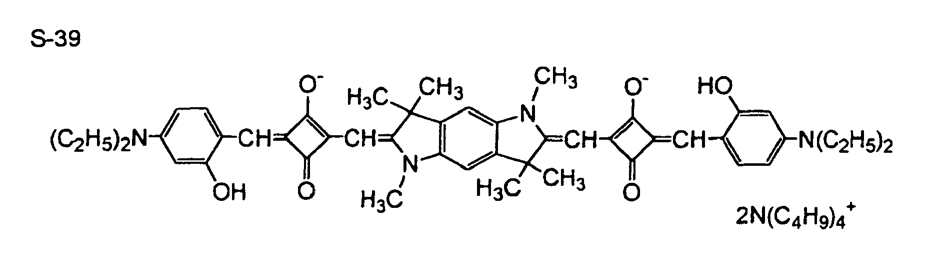

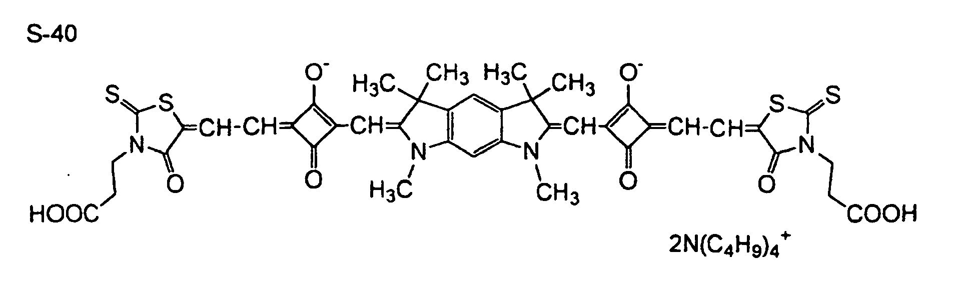

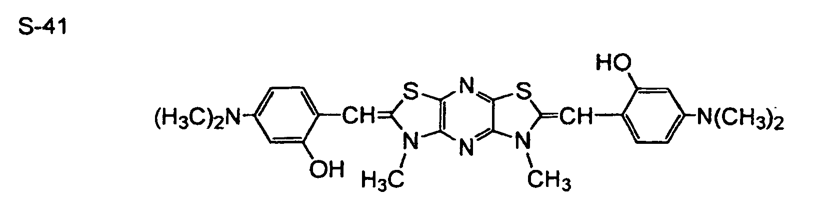

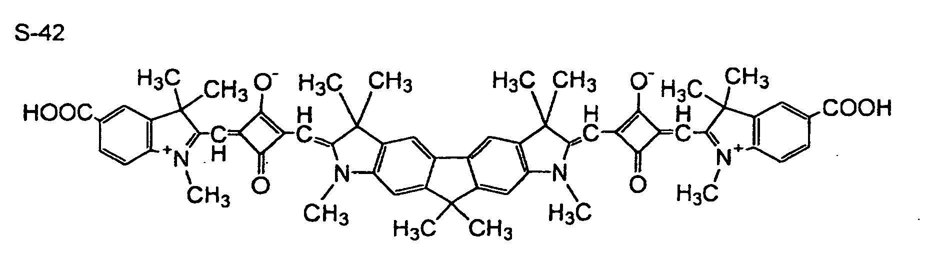

The dyes represented by the formulae (II) and (III) can be synthesized by the methods described in: F. M. Harmer, "Heterocyclic Compounds -Cyanine Dyes and Related Compounds", John Wiley & Sons, New York, London (1964); D. M. Sturmer, "Heterocyclic Compounds -Special Topics in Heterocyclic Chemistry", Chapter 18, Section 14, Page 482 to 515, John Wiley & Sons, New York, London (1977); "Rodd's Chemistry of Carbon Compounds", 2nd. Ed., Vol. IV, Part B, Chapter 15, Page 369 to 422, Elsevier Science Publishing Company Inc., New York (1977); British Patent No. 1,077,611; etc. The dyes represented by the formula (IV) can be synthesized based on the methods described in Dyes and Pigments, Vol. 21, Page 227 to 234, etc. The dyes represented by the formula (V) can be synthesized based on: Ukrainskii Khimicheskii Zhurnal, Vol. 40, No. 3, Page 253 to 258; Dyes and Pigments, Vol. 21, Page 227 to 234; and references therein.

### (4) Adsorption of Dye to Semiconductor Fine Particles

The dye may be adsorbed to the semiconductor fine particles by soaking the conductive support having the well-dried semiconductor fine particle layer in a dye solution, or by coating the dye solution to the semiconductor fine particle layer. In the former case, a soaking method, a dipping method, a roller method, an air-knife method, etc. may be used. In the soaking method, the dye may be adsorbed at a room temperature or while refluxing as described in Japanese Patent Laid-Open No. 7-249790. As a coating method of the latter, a wire-bar method, a slide-hopper method, an extrusion method, a curtain method, a spin method, a spray method, etc. may be used. As a printing method, a relief printing, an offset printing, a gravure printing, a screen-printing, etc. may be used.

A solvent for the dye solution may be properly selected in accordance with the solubility of the dye. For example, alcohols such as methanol, ethanol, *t*-butanol and benzyl alcohol; nitriles such as acetonitrile, propionitrile and 3-methoxypropionitrile; nitromethane; halogenated hydrocarbons such as dichloromethane, dichloroethane, chloroform and chlorobenzene; ethers such as diethylether and tetrahydrofuran; dimethylsulfoxide; amides such as *N,N-*dimethylformamide and *N,N*-dimethylacetamide; *N*-methylpyrrolidone; 1,3-dimethylimidazolidinone; 3-methyloxazolidinone; esters such as ethyl acetate and butyl acetate; carbonates such as diethyl carbonate, ethylene carbonate and propylene carbonate; ketones such as acetone, 2-butanone and cyclohexanone; hydrocarbons such as hexane, petroleum ether, benzene and toluene; and mixtures thereof may be used.

As is similar to the case of forming the semiconductor fine particle layer, an extrusion method and various kinds of printing methods are suitable for a high viscosity dye solution (e.g. 0.01 to 500 Poise), and a slide-hopper method, a wire bar method and a spin method are suitable for a low viscosity dye solution (e.g. 0.1 Poise or less) to form a uniform film.

Thus, the dye adsorption method may be properly selected in accordance with the viscosity of the dye solution, the coating amount, the conductive support, the coating speed, etc. It is preferable that the dye-adsorbing time after coating is as short as possible from a viewpoint of mass production.

The unadsorbed dyes are preferably removed by washing immediately after adsorption because they often cause disturbance of efficiency of the device. The washing is preferably carried out using a wet type washing bath with a polar solvent such as acetonitrile, or an organic solvent such as an alcohol-based solvent. To enhance the adsorption amount of the dye, a heat treatment is preferably carried out before the adsorption. After the heat treatment, it is preferable that the dye is quickly adsorbed at 40 to 80 °C without cooling to a room temperature to prevent adsorption of water onto the surface of the semiconductor fine particles.

The total amount of the dye is preferably 0.01 to 100 mmol per the unit surface area (1 m²) of the conductive support. The amount of the dye adsorbed to the semiconductor fine particles is preferably 0.01 to 1 mmol per 1 g of the semiconductor fine particles. Such an adsorption amount of the dye effects a sufficient sensitization to the semiconductors. If the amount of the dye is too small, the sensitization effect is not sufficient. On the other hand, if it is excessive, the dye unadsorbed to the semiconductor fine particles floats to reduce sensitization effect.

Two or more kinds of dyes may be mixed and used for the photoelectric conversion device to extend the conversion wavelength range and to increase conversion efficiency. In this case, kinds and proportion of the dyes are preferably selected in accordance with the wavelength region and the intensity distribution of a light source.

A colorless compound may be co-adsorbed onto the semiconductor fine particles together with the dye to weaken an interaction, such as association, between the dyes. As a hydrophobic compound used for the co-adsorption, a steroid compound having a carboxyl group such as chenodeoxycholic acid, etc. may be used. A UV-absorbing agent may be used together therewith.

The surface of the semiconductor fine particles may be treated with amine after dye adsorption to accelerate to remove an excessive dye. Preferable examples of the amine include pyridine, 4-*t*-butylpyridine, polyvinylpyridine, etc. The amine may be used as a solution of an organic solvent, and may be used singly when it is liquid.

### (D) Counter Electrode

The counter electrode acts as an anode when the photoelectric conversion device of the present invention is applied to the photo-electrochemical cell. The counter electrode may be a single layer of the counter electrically conductive layer of an electrically conductive material, or two layers of the counter electrically conductive layer and the substrate, as is similar to the above-described conductive support. The conductive material for the counter electrically conductive layer may be: a metal such as platinum, gold, silver, copper, aluminum, rhodium and indium; carbon; or an electrically conductive metal oxide such as indium-tin composite oxide and fluorine-doped tin oxide. The substrate for the counter electrode is preferably made of glass or plastic, the counter electrically conductive layer being coated or vapor-deposited thereon.

The thickness of the counter electrically conductive layer is not particularly limited, preferably 3 nm to 10 µm. In the case of the metal counter electrically conductive layer, the thickness thereof is preferably 5 µm or less, more preferably 5 nm to 3 µm.

Light may be irradiated from any one or both side of the conductive support and the counter electrode, so that at least one of them must be substantially transparent to have light reached to the photosensitive layer. From a viewpoint of improving electric generation efficiency, it is preferable that the conductive support is transparent to irradiate light therethrough. In this case, the counter electrode preferably has a light-reflective property. Such a counter electrode may be composed of glass or plastic having a vapor-deposited layer of metal or electrically conductive oxide, or metal thin film, etc.

The counter electrode may be disposed (i) on the charge transfer layer formed beforehand, or (ii) on the photosensitive layer through a spacer before forming the charge transfer layer. In the case of (i), the counter electrode may be disposed by: directly coating, metal-plating, or vapor-depositing (PVD, CVD, etc.) the electrically conductive material on the charge transfer layer; or laminating the electrically conductive layer formed on the substrate on the charge transfer layer. In the case of (ii), the counter electrode is disposed and fixed onto the photosensitive layer through the spacer, and the open ends therebetween is soaked in the electrolyte composition. The electrolyte composition penetrates into the voids between the counter electrode and the photosensitive layer by capillarity or reduced pressure.

Similar to the case of the conductive support, it is preferable to use the metal lead for reducing the resistance of the electrode particularly in the case of the transparent counter electrode. Preferable embodiments of the metal lead are the same as those in the case of the conductive support mentioned above.

### (E) Others

Functional layers such as a protective layer and a reflection-preventing layer may be disposed on any one or both of the conductive support and the counter electrode each acting as the electrode. Such functional layers may be formed in a fashion of multi-layers by a simultaneous multi-layer coating method or a successive coating method. Of these methods, the simultaneous multi-layer coating method is preferred from a viewpoint of productivity. As for the simultaneous multi-layer coating method, a slide-hopper method and an extrusion method are preferable from the viewpoint of the productivity and homogeneity of a coated film. The functional layers may be disposed by a method selected in accordance with the materials therefor, such as a vapor-deposition method and a sticking method.

An undercoating layer, which may be composed of a semiconductor thin film, may be disposed between the conductive support and the photosensitive layer to prevent short-circuit of the device. Preferable materials for the undercoating layer include TiO₂, SnO₂, Fe₂O₃, WO₃, ZnO and Nb₂O₅. Among them, TiO₂ is more preferred. The undercoating layer may be disposed by a spray-pyrolysis method described in Electrochim. Acta, 40, 643 to 652 (1995). The thickness of the undercoating layer is preferably 5 to 1000 nm, more preferably 10 to 500 nm.

### (F) Interior Structure of Photoelectric Conversion Device

As described above, the photoelectric conversion device may have various interior structures in accordance with an end of use. The structures are classified into two major forms, a structure allowing light incidence from both faces, and a structure allowing it from only one face. Each of Figs. 2 to 9 illustrates an example of the interior structure of the photoelectric conversion device, which is preferable in the present invention.

As for the structure illustrated in Fig. 2, the photosensitive layer 20 and the charge transfer layer 30 are disposed between the transparent electrically conductive layer 10a and the transparent counter electrically conductive layer 40a. This structure allows light incidence from both faces of the device.

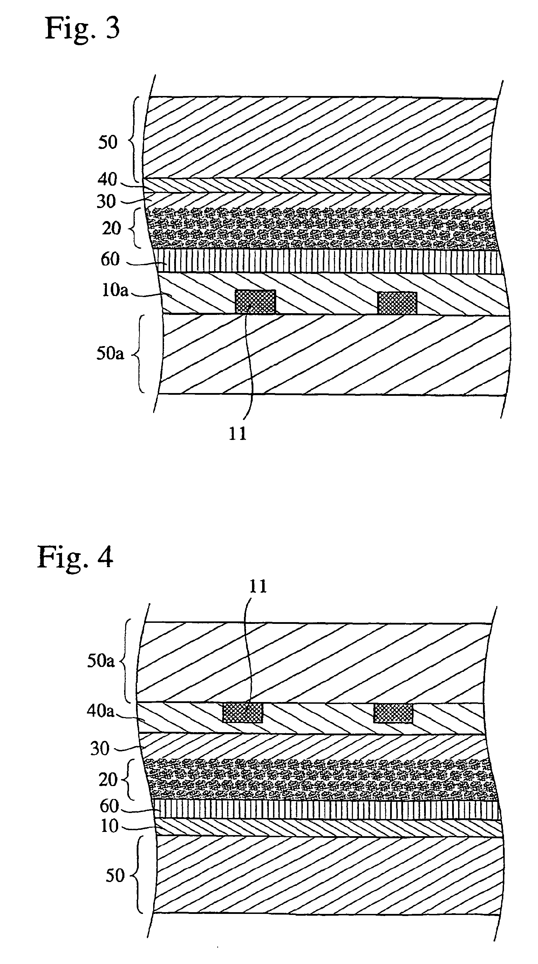

As for the structure illustrated in Fig. 3, on the transparent substrate 50a partially having the metal lead 11 is disposed the transparent electrically conductive layer 10a, the undercoating layer 60, the photosensitive layer 20, the charge transfer layer 30 and the counter electrically conductive layer 40 are laminated in this order, and the substrate 50 is further placed thereon. This structure allows light incidence from the electrically conductive layer side.

As for the structure illustrated in Fig. 4, the photosensitive layer 20 is disposed on the substrate 50 having the electrically conductive layer 10 through the undercoating layer 60, the charge transfer layer 30 and the transparent counter electrically conductive layer 40a are disposed thereon, and further the transparent substrate 50a locally having the metal lead 11 is placed on the counter electrically conductive layer 40a so that the metal lead 11 side orients inward. This structure allows light incidence from the counter electrode side.

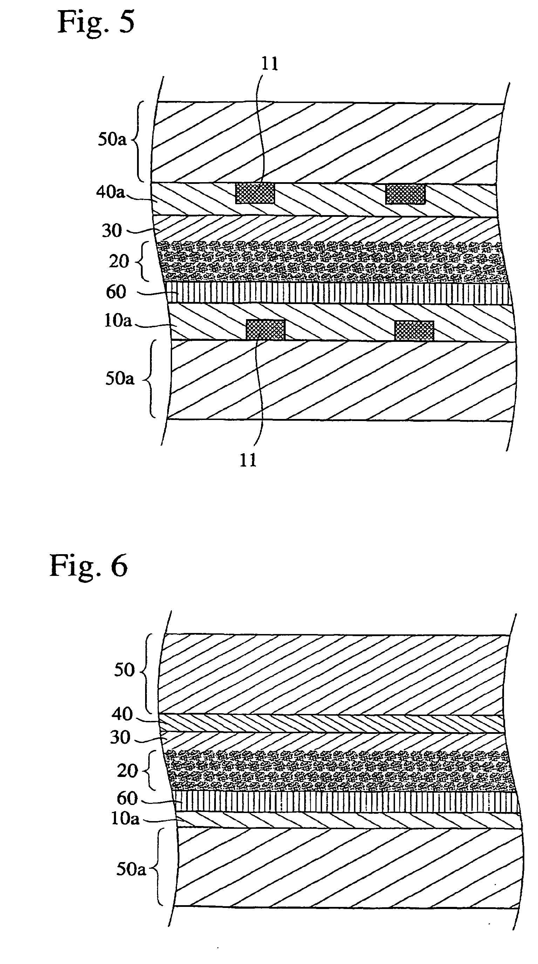

As for the structure illustrated in Fig. 5, on the two transparent substrates 50a each having the metal lead 11 partially are formed the transparent electrically conductive layer 10a and the transparent counter electrically conductive layer 40a, respectively, and the undercoating layer 60, the photosensitive layer 20 and the charge transfer layer 30 placed between the conductive layers. This structure allows light incidence from both faces of the photoelectric conversion device.

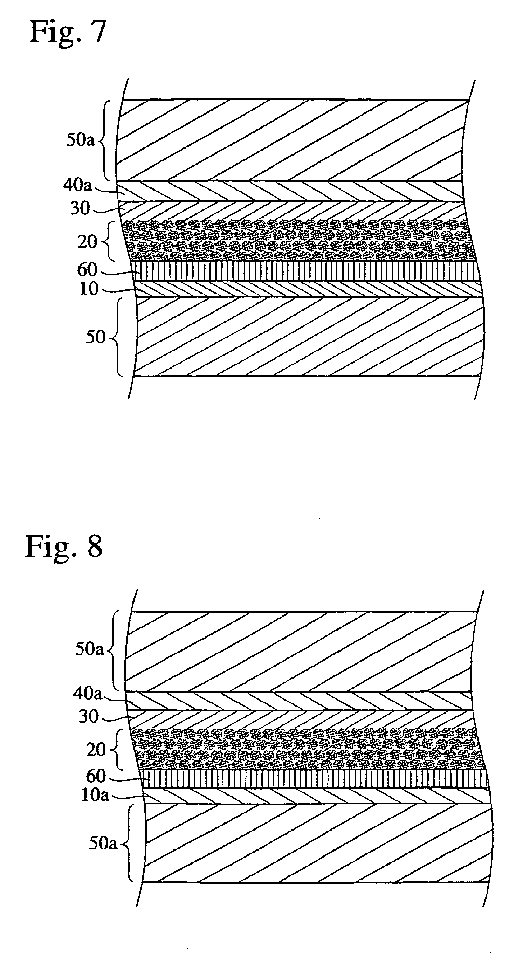

As for the structure illustrated in Fig. 6, on the transparent substrate 50a having the transparent electrically conductive layer 10a is disposed the photosensitive layer 20 through the undercoating layer 60, the charge transfer layer 30 and the counter electrically conductive layer 40 are formed thereon, and further the substrate 50 is placed on the counter electrically conductive layer 40. This structure allows light incidence from the electrically conductive layer side.

As for the structure illustrated in Fig. 7, on the substrate 50 having the electrically conductive layer 10 is disposed the photosensitive layer 20 through the undercoating layer 60, the charge transfer layer 30 and the transparent counter electrically conductive layer 40a are formed thereon, and further the transparent substrate 50a is placed on the layer 40a. This structure allows light incidence from the counter electrode side.

As for the structure illustrated in Fig. 8, on the transparent substrate 50a having the transparent electrically conductive layer 10a is disposed the photosensitive layer 20 through the undercoating layer 60, the charge transfer layer 30 and the transparent counter electrically conductive layer 40a are formed thereon, and further the transparent substrate 50a is placed on the layer 40a. This structure allows light incidence from both faces of the photoelectric conversion device.

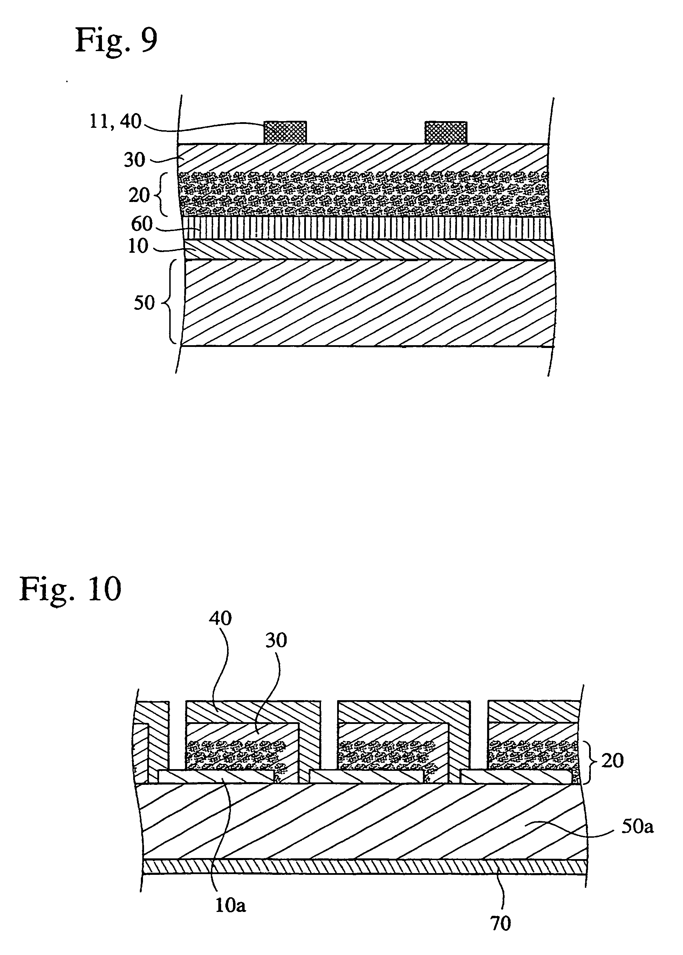

As for the structure illustrated in Fig. 9, the photosensitive layer 20 is disposed on the substrate 50 having the electrically conductive layer 10 through the undercoating layer 60, the solid charge transfer layer 30 is disposed thereon, and further the counter electrically conductive layer 40 or the metal lead 11 is locally placed on the solid charge transfer layer 30. This structure allows light incidence from the counter electrode side.

### [2] Photo-Electrochemical Cell

The photo-electrochemical cell of the present invention is composed of the above-described photoelectric conversion device designed to work in the outer circuit. The side face of the photo-electrochemical cell is preferably sealed with a polymer or an adhesive agent, etc. to prevent deterioration and volatility of the content in the cell. The outer circuit is connected to the conductive support and the counter electrode via a lead. Various known circuits may be used in the present invention.

### [3] Solar Cell

In the case where the photoelectric conversion device of the present invention is applied to so-called solar cell, the interior structure of the solar cell may be essentially the same as that of the photoelectric conversion device mentioned above. Module structures of the solar cell comprising the photoelectric conversion device of the present invention will be explained below.

The solar cell may have the same module structure as that of prior art solar cells. The solar cell module generally has a structure where cells are placed on a substrate of metal, ceramic, etc. and covered with a packing resin, a protective glass, etc. Light is introduced from the opposite side of the substrate. The solar cell module may also have a structure where the cells are placed on a substrate of a transparent material such as a tempered glass to introduce light from the transparent substrate side. Specifically, a superstraight type module structure, a substrate type module structure, a potting type module structure, substrate-integrated type module structure that is generally used in amorphous silicon solar cells, etc. are known as the solar cell module structure. The solar cell comprising the photoelectric conversion device of the present invention may have a module structure properly selected from the above structures in accordance with ends, environment at use.

The super straight type module and the substrate type module generally have a structure where the cells are placed at a regular intervals between substrates and connected by a metal lead, a flexible wirering, etc., and collector electrodes are placed at the outer marginal portion to deliver generated electric power to the outside. The substrate is subjected to a reflection-preventing treatment, and any one or both side thereof is transparent. Between the substrate and the cell may be disposed various kinds of plastic material such as ethylene vinyl acetate (EVA) to protect the cell or to improve a collector efficiency. Such a plastic material is may be used in a form of a film or a packing resin. In the case where the solar cell is used at a place where the surface of the cell is not necessarily covered with a hard material, such as a place without a shock from the outside, one of the substrate can be omitted by forming a surface protective layer of a transparent plastic film, or by hardening the above-described packing resin to protect the cell. To secure rigidity of the module, the periphery of the substrates may be sandwiched and fixed by metallic flames, and the substrates and the flames may be sealed with a sealant to seal the interior of the cell and. Further, flexible materials may be used for the cell, the substrate, the packing material or the sealant, to constructing the solar cell on a curved surface.

The super straight type solar cell module may be manufactured by the following steps of: placing cells, lead lines for connecting a sealant to the cells and a sealant for back surface on a front substrate sent out from a substrate-supplying apparatus while carrying the front substrate by a belt conveyer, etc.; placing a back substrate or a back cover thereon; and setting flames at the outer edge portion.

The substrate type solar cell may be manufactured by the following steps of: placing cells and lead lines for connecting the cells, a sealant, etc. on a substrate sent out from a substrate-supplying apparatus while carrying the substrate by a belt conveyer, etc.; placing a front cover thereon; and setting flames at the outer edge portion.

Fig. 10 shows a structure of an embodiment of the substrate-integrated type solar cell produced by modularizing a photoelectric conversion device of the present invention. The solar cell shown in Fig. 10 has a structure where cells having the transparent electrically conductive layer 10a, the photosensitive layer 20 containing dye-adsorbed TiO₂, the charge transfer layer 30 and the metal counter electrically conductive layer 40 are modularized on one surface of the transparent substrate 50a, the reflection-preventing layer 70 being disposed on the other surface of the transparent substrate 50a. In such a structure, it is preferable that the area ratio of the photosensitive layer 20 observed from the substrate 50a side is increased to enhance a utilizing efficiency of incident light.

As for the solar cell shown in Fig. 10, a desired module structure, in which the transparent electrically conductive layers, the photosensitive layers, the charge transfer layers and the counter electrodes etc. are three-dimensionally arranged at a regular interval on the substrate, can be obtained by patterning the layers, etc. accordingly to a semiconductor process technique such as selective metal plating, selective etching, CVD, PVD, etc., or a mechanical method such as laser scribing, plasma CVM, polishing, etc. The plasma CVM is described in Solar Energy Materials and Solar Cells, 48, Page 373 to 381, etc.

Other materials and processes used in the solar cell comprising the photoelectric conversion device of the present invention will be described in detail below.

As a material for the sealant, various materials such as a liquid EVA (ethylene vinyl acetate), an EVA film, a mixture of fluorinated vinylidene copolymer and an acrylic resin, etc. may be used in accordance with objects such as application of weather-resistance or electric insulation, improvement in light-condensing efficiency, protection of a cell (improvement in impact resistance), etc. The outer edge of the module and the frame surrounding the module are preferably sealed with the sealant having high weather-resistance and moisture resistance. The strength and light transmittance of the sealed cell can be increased by adding a transparent filter into the sealant.

The sealant may be fixed to the cell by a method properly selected in accordance with a property of the sealant. For example, the film sealant may be fixed to the cell by roll pressurization followed by thermal adherence, vacuum pressurization followed by thermal adherence, etc., and the liquid or paste sealant may be fixed by roll coating, bar coating, spray coating, screen printing, etc.

The substrate is preferably made of a flexible material such as PET and PEN. In this case, the cells can be disposed on a substrate roll, and the sealant may be successively fixed to the cells, thereby improving productivity.

To increase electric power production efficiency, the light-taking surface of the substrate, which is generally tempered glass substrate, may be subjected to a reflection-preventing treatment. The reflection-preventing treatment may be achieved by laminating a reflection-preventing film, coating a reflection-preventing layer, etc.

The surface of the cell may be grooved or textured. This improves incident light-utilizing efficiency of the cell.

To increase the electric power production efficiency, it is important that light is taken into the module without loss, and additionally, that light reached to the inside of the solar cell through a photosensitive layer is effectively reflected and returned to the photosensitive layer. The light reflectance may be increased by: mirror plane-polishing the substrate and vapor-depositing or metal-plating the substrate with Ag, Al, etc.; disposing a reflective layer of an Al-Mg alloy, an Al-Ti alloy, etc. on the substrate; making a texture structure on the substrate by annealing.

To increase the electric power production efficiency, it is also important that the resistance of connection between the cells is lowered to prevent reduction in an inner voltage. The cells are generally connected each other by a wire bonding or an electrically conductive flexible sheet. The cells may be electrically connected while fixing the cells by an electrically conductive adhesives, adhesive tapes, etc., and may be connected by pattern-coating an electrically conductive hot melt.

A flexible solar cell may be produced by a method comprising the steps of: disposing the cells on the flexible substrate made of a polymer film, etc. in the same manner as described above while sending out a roll-like substrate; cutting the substrate to an intended size; and sealing the marginal portion thereof with a flexible, moisture resistant material. The solar cell may have a module structure called "SCAF" described in Solar Energy Materials and Solar Cells, 48, Page 383 to 391. Further, the solar cell using the flexible substrate may be adhered and fixed to a curved glass, etc.

As described above in detail, the solar cell comprising the photoelectric conversion device of the present invention may have various forms and functions, which are selected depending on its ends and environment of use.

### EXAMPLES

The present invention will be explained in more detail with reference to examples below. The present invention is not restricted by these examples.

### 1. Preparation of Titanium Dioxide Dispersion

A 200 ml inner volume of a stainless steel vessel coated with Teflon inside was charged with 15 g of titanium dioxide fine particles "Degussa P-25" manufactured by Nippon Aerosil K.K., 45 g of water, 1 g of dispersant "Triton X-100" manufactured by Aldrich, and 30 g of zirconia beads having a diameter of 0.5 mm manufactured by Nikkato K.K. These contents were subjected to a dispersion treatment for 2 hours at 1500 rpm by means of a sand-grinder mill manufactured by Imex K.K. The zirconia beads were removed by filtration to obtain the titanium dioxide dispersion. The average particle diameter of the titanium dioxide particles in the dispersion was 2.5 µm. Incidentally, the particle diameter was measured by Master Sizer manufactured by MALVERN.

### 2. Preparation of Dye-Adsorbed TiO₂ Electrode

The above titanium dioxide dispersion was coated on an electrically conductive surface of a conductive glass having a fluorine-doped tin oxide layer by a glass bar. Used as the conductive glass was 20 mm x 20 mm of "TCO Glass-U" manufactured by Asahi Glass K.K. with a surface resistance of approximately 30 Ω/square. A coating amount of the semiconductor fine particles was 20 g/m². Herein, on the eight glasses were coated the titanium dioxide dispersion at once after adhesive tape was attached to a part of the conductive surface (3 mm from the edge) of each conductive glass as a spacer, and the glasses were arranged so that the adhesive tapes come to both edges thereof. The coated glass was air-dried for a day at a room temperature after peeling the adhesive tapes.

Then, the glass was placed in an electric furnace "muffle furnace FP-32" manufactured by Yamato Science K.K., followed by calcinating at 450 °C for 30 minutes to obtain TiO₂ electrode. After the TiO₂ electrode was taken out of the furnace and cooled, the electrode was immersed in an ethanol solution comprising the dye R-1 for 3 hours to adsorbing the dye. The concentration of the dye R-1 in the ethanol solution was 3 × 10⁻⁴ mol/l. The dye-adsorbed TiO₂ electrode was further immersed in 4-*t*-butylpyridine for 15 minutes, then washed with ethanol and air-dried. The thickness of thus-obtained photosensitive layer was 6.6 µm.

### 3. Production of Photo-Electrochemical Cell

The 20 mm × 20 mm in size of the glass substrate containing a dye-sensitized TiO₂ prepared as described above was put on a platinum-vapor deposited glass having the same size. Next, each electrolyte composition shown in Table 1 was permeated into a crevice between the glasses through capillarity and introduced into the TiO₂ electrode, to obtain a photo-electrochemical cell. According to this example, each of the photo-electrochemical cells according to EXAMPLES 1 to 17 and COMPARATIVE EXAMPLES 1 to 11 similar to that shown in Fig. 1 was prepared, where the conductive support of the electrically conductive glass comprising the transparent substrate 50a of glass and the electrically conductive layer 10a disposed thereon; the photosensitive layer 20 of the dye-sensitized TiO₂; the charge transfer layer 30; the counter electrically conductive layer 40 of platinum; and the transparent substrate 50a of glass were laminated in this order, and sealed with an epoxy-based sealant. Incidentally, in the case where the electrolyte composition has a high viscosity, whereby it is difficult to permeating it through capillarity, the photo-electrochemical cell was produced by the method comprising the steps of: warming the electrolyte composition to 50 °C; applying it on the TiO₂ electrode; sufficiently permeating the electrolyte composition into the electrode and removing air in the electrode under reduced pressure; and putting a platinum-deposited counter electrode glass thereon. In the Table 1, "BCE" represents bis(cyanoethyl) ether. Further, the weight ratio to the entire electrolyte composition of each of the metal cation, and SCN⁻ and and an anion represented by the general formula (1), which is referred to as "anion" in Table 1, was also shown in Table 1.

**Table 1.**

| Photo-Electrochemical Cell | Electrolyte Composition Comprising 2 weight % of Iodine | | Metal Cation weight % | Anion weight % |
|---|---|---|---|---|
| | Salt (weight %) | Solvent (weight %) | | |
| Comp. Ex. 1 | Y8-1(10) | BCE(88) | ― | ― |
| Comp. Ex. 2 | Y8-1(10) / Lil(5) | BCE(83) | 0.26 | ― |
| Ex. 1 | Y8-1(10) / 1-1a(5) | BCE(83) | 0.29 | 4.7 |
| Ex 2 | Y8- 1(10) / 1-1b(5) | BCE(83) | 0.85 | 4.15 |
| Ex.3 | Y8-1(10) / 2-1(5) | BCE(83) | 0.53 | 4 47 |
| Ex. 4 | Y8- 1(10) / 2-2(5) | BCE(83) | 1.42 | 3.58 |
| Comp Ex. 3 | Y8-1(30) / Y7-2(13) / Lil(5) | BCE(50) | 0.26 | ― |
| Comp. Ex. 4 | Y8-1(50) / Y7-2(23) / Lil(5) | BCE(20) | 0.26 | ― |
| Camp. Ex. 5 | Y8-1(50) / Y7-2(33) / Lil(5) | BCE(10) | 0.26 | ― |
| Ex. 5 | Y8-1(30) / Y7-2(13) / 1-1a(5) | BCE(50) | 0.29 | 4.7 |
| Ex. 6 | Y8-1(50) / Y7-2(23) / 1-1a(5) | BCE(20) | 0.29 | 4.7 |
| Ex 7 | Y8-1(50) / Y7-2(33) / 1-1a(5) | BCE(10) | 0.29 | 4.7 |
| Comp. Ex. 6 | Y8-1(70) / Y7-2(28) | ― | ― | ― |
| Comp. Ex. 7 | Y8-1(70) / Y7-2(23) / Lil(5) | ― | 0.26 | ― |
| Comp. Ex. 8 | Y10-1 (70) / Y7-2(23) / Lil(5) | ― | 0.26 | ― |
| Comp. Ex. 9 | Y10-1(70) / Y7-5(28) | ― | ― | 14.1 |
| Ex 8 | Y8-1(70) / Y7-2(23) / 1-1a(5) | ― | 0.29 | 4.7 |
| Ex. 9 | Y10-1(70) / Y7-2(23) / 1-1a(5) | ― | 0.29 | 4.7 |
| Ex. 10 | Y10-1(70) / Y7-5(23) / 1-1a(5) | ― | 0.29 | 16.3 |
| Ex. 11 | Y10-1(70) / Y7-5(23) / 1-1b(5) | ― | 0.85 | 15.8 |
| Ex. 12 | Y10-1(70) / Y7-5(24) / 1-1a(2) / 1-1b(2) | ― | 0.46 | 15.6 |
| Ex. 13 | Y10-1(70) / Y7-2(23) / 2-1(5) | ― | 0.53 | 4.47 |
| Ex. 14 | Y10-1(70) / Y7-2(23) / 2-2(5) | ― | 1.42 | 3.58 |
| Ex. 15 | Y10-1(70) / Y7-5(24) / 1-1a(2) / 2-1(2) | ― | 0.33 | 15.8 |
| Ex. 16 | Y10-1(70) / Y7-5(23) / 1-4a(5) | ― | 0.48 | 4.5 |
| Ex. 17 | Y10-1(70) / Y37-2(23) / 1-1a(5) | ― | 0.29 | 4.7 |
| Comp. Ex. 10 | YB-1(25) / Y7-5(23) / 2-3(50) | ― | 2.6 | 16.3 |
| Comp. Ex. 11 | Y8-1(25) / Y7-5(68) / 1-1a(5) | ― | 0.29 | 39 0 |

### 4. Measurement of Photoelectric Conversion Efficiency

A simulated sunlight was irradiated to the photo-electrochemical cells of EXAMPLES and COMPARATIVE EXAMPLES at 50°C, and the generated electricity was measured by the current-voltage tester "Keithley SMU238", to obtain open circuit voltage (Voc), short-circuit current density (Jsc), fill factor (FF), photoelectric conversion efficiency (η), and decrease (%) of short-circuit current density after storage in the dark for 75 hours with respect to each of the cells. The results are shown in Table 2. Incidentally, the simulated sunlight was obtained by passing the light of a 500 W xenone lamp manufactured by Ushio K.K. through an "AM 1.5 filter" manufactured by Oriel Co. and a sharp cut filter "Kenko L-42". The simulated sunlight was free of an ultraviolet radiation, and had intensity of 100 mW/cm².

**Table 2.**

| Photo-Electrochemical Cell | Open Circuit Voltage (Voc) V | Short-Circuit Current Density (Jsc) mA/cm² | Fill Factor (FF) | Photoelectric Conversion Efficiency (η) % | Decrease of Jsc after Storage for 75 hours % |
|---|---|---|---|---|---|
| Comp. Ex. 1 | 0.61 | 13.1 | 0.66 | 5.3 | 88 |
| Comp. Ex. 2 | 0.57 | 14.2 | 0.65 | 5.3 | 86 |
| Ex. 1 | 0.62 | 13.7 | 0.67 | 5.7 | 87 |
| Ex.2 | 0.64 | 13.4 | 0.66 | 5.7 | 85 |
| Ex. 3 | 0.56 | 15.0 | 0.66 | 5.5 | 84 |
| Ex. 4 | 0.59 | 14.4 | 0.66 | 5.6 | 85 |
| Comp. Ex. 3 | 0.56 | 13.5 | 0.65 | 4.9 | 54 |
| Comp. Ex. 4 | 0.56 | 11.9 | 0.65 | 4.3 | 20 |
| Comp. Ex. 5 | 0.55 | 10.5 | 0.65 | 3.8 | 13 |
| Ex. 5 | 0.60 | 13.1 | 0.66 | 5.2 | 53 |
| Ex 6 | 0.59 | 12.1 | 0.65 | 4.6 | 19 |
| Ex. 7 | 0.58 | 10.9 | 0.65 | 4.1 | 8 |
| Comp. Ex. 6 | 0.53 | 8.5 | 0.65 | 2.9 | 4 |
| Comp. Ex. 7 | 0.49 | 11.7 | 0.57 | 3.3 | 4 |
| Comp. Ex. 8 | 0.51 | 12.5 | 0.60 | 3.8 | 4 |
| Comp. Ex. 9 | 0.58 | 8.3 | 0.64 | 3.1 | 4 |
| Ex. 8 | 0.55 | 12.6 | 0.65 | 4.5 | 3 |
| Ex. 9 | 0.60 | 12.9 | 0.65 | 5.0 | 2 |
| Ex. 10 | 0.62 | 12.5 | 0.66 | 5.1 | 3 |
| Ex 11 | 0.64 | 12.0 | 0.66 | 5.1 | 3 |
| Ex. 12 | 0.64 | 12.5 | 0.66 | 5.3 | 3 |
| Ex. 13 | 0.55 | 13.1 | 0.66 | 4.8 | 3 |
| Ex. 14 | 0.58 | 12.8 | 0.65 | 4.8 | 3 |
| Ex. 15 | 0.61 | 13.1 | 0.65 | 5.2 | 3 |
| Ex. 16 | 0.62 | 12.4 | 0.66 | 5.1 | 3 |
| Ex. 17 | 0.60 | 13.2 | 0.65 | 5.1 | 3 |
| Comp. Ex. 10 | 0.40 | 5.6 | 0.38 | 0.85 | 4 |
| Comp. Ex. 11 | 0.66 | 5.1 | 0.45 | 1.5 | 4 |

As shown in Table 2, the photo-electrochemical cells of the present invention were superior to the comparative photo-electrochemical cells in photoelectric conversion efficiency whether the cell comprises the solvent or not. Further, the photoelectric conversion properties of the cells using the electrolyte composition with a large amount of solvent were remarkably worsened during the storage, and it was found that to suppress the decrease of the short-circuit current density during the storage to 10 % or less, the electrolyte composition preferably comprised 10 weight % or less of solvent, more preferably comprised no solvent. Furthermore, the photo-electrochemical cells according to COMPARATIVE EXAMPLES 10 and 11 used the electrolyte composition comprising excess amount of the metal cation, SCN⁻ and an anion represented by the general formula (1), thereby exhibiting remarkably low photoelectric conversion efficiency.

As explained above in detail, the photoelectric conversion device of the present invention exhibits the excellent photoelectric conversion properties and less deterioration of the properties during the long-term use or storage. The photo-electrochemical cell composed of the device is remarkably useful as a solar cell.

## Claims

1. A photoelectric conversion device having a conductive support, a photosensitive layer (20) containing a semiconductor (21), a charge transfer layer (30) containing an electrolyte composition, and a counter electrode (40), wherein said electrolyte composition comprises 0.01 to 2.5 weight % of a metal cation, and 1 to 30 weight % of SCN⁻ and an anion represented by the following general formula (1):
R_{f}-COO⁻ (1)
wherein R_{f} represents an alkyl group substituted by at least one fluorine atom, wherein said metal cation is a lithium ion, a sodium ion or a magnesium ion, and wherein said electrolyte composition comprises a molten salt.

2. The photoelectric conversion device according to claim 1, wherein said electrolyte composition comprises 0.02 to 2 weight % of said metal cation.

3. The photoelectric conversion device according to claim 1 or 2, wherein said R_{f} in the general formula (1) is a perfluoroalkyl group having 1 to 10 carbon atom.

4. The photoelectric conversion device according to any one of claims 1 to 3, wherein said electrolyte composition comprises 10 weight % or less of a solvent.

5. The photoelectric conversion device according to any one of claims 1 to 4', wherein said electrolyte composition comprises an iodine salt and iodine.

6. The photoelectric conversion device according to any one of claims 1 to 5, wherein said photosensitive layer contains semiconductor fine particles sensitized by a dye.

7. The photoelectric conversion device according to any one of claims 1 to 6, wherein said semiconductor is composed of a metal chalcogenide.

8. The photoelectric conversion device according to claim 7; wherein said metal chalcogenide is titanium oxide.

9. The photoelectric conversion device according to any one of claims 6 to 8, wherein said dye is a metal complex dye and/or a polymethine dye.

10. A photo-electrochemical cell composed of the photoelectric conversion device recited in any one of claims 1 to 9.

## Patentansprüche

1. Fotoelektrische Umsetzvorrichtung, aufweisend einen leitenden Träger, eine fotosensitive Schicht (20) enthaltend einen Halbleiter (21), eine Ladungsübertragungsschicht (30) enthaltend eine Elektrolytzusammensetzung und eine Gegenelektrode (40), wobei besagte Elektrolytzusammensetzung 0,01 bis 2,5 Gew.-% eines Metallkations und 1 bis 30 Gew.-% SCN⁻ und ein Anion, dargestellt durch die folgende allgemeine Formel (1), aufweist:
R_{f} - COO⁻ (1)
wobei R_{f} eine Alkylgruppe substituiert mit mindestens einem Fluoratom darstellt, wobei besagtes Metallkation ein Lithiumion, ein Natriumion oder ein Magnesiumion ist, und wobei besagte Elektrolytzusammensetzung ein geschmolzenes Salz umfasst.

2. Fotoelektrische Umsetzvorrichtung gemäß Anspruch 1, wobei besagte Elektrolytzusammensetzung 0,02 bis 2 Gew.-% des besagten Metallkations aufweist.

3. Fotoelektrische Umsetzvorrichtung gemäß Anspruch 1 oder 2, wobei besagter R_{f} in der allgemeinen Formel (1) eine Perfluoralkylgruppe darstellt, die 1 bis 10 Kohlenstoffatome aufweist.

4. Fotoelektrische Umsetzvorrichtung gemäß einem der Ansprüche 1 bis 3, wobei besagte Elektrolytzusammensetzung 10 Gew.-% oder weniger eines Lösungsmittels umfasst.

5. Fotoelektrische Umsetzvorrichtung gemäß einem der Ansprüche 1 bis 4, wobei besagte Elektrolytzusammensetzung ein Jodsalz oder Jod umfasst.

6. Fotoelektrische Umsetzvorrichtung gemäß einem der Ansprüche 1 bis 5, wobei besagte fotosensitive Schicht Farbstoffsensibilisierte Halbleiterfeinpartikel enthält.

7. Fotoelektrische Umsetzvorrichtung gemäß einem der Ansprüche 1 bis 6, wobei besagter Halbleiter aus einem Metallchalkogenid besteht.

8. Fotoelektrische Umsetzvorrichtung gemäß Anspruch 7, wobei besagtes Metallchalkogenid Titanoxid ist.

9. Fotoelektrische Umsetzvorrichtung gemäß einem der Ansprüche 6 bis 8, wobei besagter Farbstoff ein Metallkomplexfarbstoff und/oder ein Polymethinfarbstoff ist.

10. Fotoelektrochemische Zelle bestehend aus der fotoelektrischen Umsetzvorrichtung aufgezählt in einem der Ansprüche 1 bis 9.

## Revendications

1. Dispositif de conversion photoélectrique disposant d'un support conducteur, d'une couche (20) photosensible contenant un semi-conducteur (21), d'une couche (30) de transfert de charge contenant une composition d'électrolyte, et d'une contre-électrode (40), dans lequel ladite composition d'électrolyte comprend de 0,01 à 2,5 % en poids d'un cation métallique, et de 1 à 30 % en poids de SCN et un anion représenté par la formule générale (1) suivante :
R_{f}―COO⁻ (1)
dans laquelle R_{f} représente un groupe alkyle substitué par au moins un atome de fluor, dans lequel ledit cation métallique est un ion de lithium, un ion de sodium ou un ion de magnésium, et dans lequel ladite composée d'électrolyte comprend un sel fondu.

2. Dispositif de conversion photoélectrique selon la revendication 1, dans lequel ladite composition d'électrolyte comprend de 0,02 à 2 % en poids dudit cation métallique.

3. Dispositif de conversion photoélectrique selon la revendication 1 ou 2, dans lequel ledit R_{f} de la formule générale (1) est un groupe perfluoroalkyle ayant de 1 à 10 atomes de carbone.

4. Dispositif de conversion photoélectrique selon l'une quelconque des revendications 1 à 3, dans lequel ladite composition d'électrolyte comprend 10 % en poids ou moins d'un solvant.

5. Dispositif de conversion photoélectrique selon l'une quelconque des revendications 1 à 4, dans lequel ladite composition d'électrolyte comprend un sel d'iode et de iode.

6. Dispositif de conversion photoélectrique selon l'une quelconque des revendications 1 à 5, dans lequel ladite couche photosensible contient des particules fines de semi-conducteur sensibilisées grâce à un colorant.

7. Dispositif de conversion photoélectrique selon l'une quelconque des revendications 1 à 6, dans lequel ledit semi-conducteur est composé d'un chalcogénure métallique.

8. Dispositif de conversion photoélectrique selon la revendication 7, dans lequel ledit chalcogénure métallique est de l'oxyde de titane.

9. Dispositif de conversion photoélectrique selon l'une quelconque des revendications 6 à 8, dans lequel ledit colorant est un colorant au complexe métallique et/ou un colorant polyméthine.

10. Cellule photoélectrochimique composée du dispositif de conversion photoélectrique selon l'une quelconque des revendications 1 à 9.
